(19) Europäisches Patentamt
European Patent Office
Office européen des brevets

(11) EP 2 985 142 A1

(12) **EUROPEAN PATENT APPLICATION**
published in accordance with Art. 153(4) EPC

(43) Date of publication:
**17.02.2016 Bulletin 2016/07**

(21) Application number: **14783153.1**

(22) Date of filing: **09.04.2014**

(51) Int Cl.:
***B32B 7/02*** *(2006.01)* ***B32B 27/36*** *(2006.01)*
***H01L 41/193*** *(2006.01)*

(86) International application number:
**PCT/JP2014/060340**

(87) International publication number:
**WO 2014/168188 (16.10.2014 Gazette 2014/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.04.2013 JP 2013082392**
**23.04.2013 JP 2013090766**
**07.02.2014 JP 2014022550**

(71) Applicant: **Mitsui Chemicals, Inc.**
**Tokyo 105-7117 (JP)**

(72) Inventors:
- **TANIMOTO, Kazuhiro**
  **Sodegaura-shi**
  **Chiba 299-0265 (JP)**
- **ASANO, Yohsuke**
  **Sodegaura-shi**
  **Chiba 299-0265 (JP)**
- **YOSHIDA, Mitsunobu**
  **Sodegaura-shi**
  **Chiba 299-0265 (JP)**
- **NISHIKAWA, Shigeo**
  **Nagoya-shi**
  **Aichi 457-8522 (JP)**

(74) Representative: **Hoffmann Eitle**
**Patent- und Rechtsanwälte PartmbB**
**Arabellastraße 30**
**81925 München (DE)**

(54) **LAMINATE**

(57) A layered body including a crystalline polymeric piezoelectric body, which is molecularly oriented, and a surface layer, in which the relationship between the tensile modulus E (GPa) and the thickness d (μm) satisfies the following Formula (A):

$$0.6 \leq Ec / d \qquad \text{Formula (A).}$$

EP 2 985 142 A1

**Description**

Technical Field

The present invention relates to a layered body.

Background Art

A polymeric piezoelectric material using a helical chiral polymer having optical activity (for example, poly(lactic acid)-type polymer) has been reported recently.
For example, a polymeric piezoelectric material, which is prepared by stretching a formed product of poly(lactic acid) and exhibits piezoelectric modulus of approx. 10 pC/N at normal temperature, has been disclosed (for example, refer to Japanese Patent Application Laid-Open (JP-A) No. H5-152638).
Further, use of a special orientation method for achieving high orientation of a poly(lactic acid) crystal called as a forging method, which exhibits piezoelectricity as high as approx. 18 pC/N, has been also reported (for example, refer to JP-A No. 2005-213376).
Meanwhile, a touch panel using a poly(lactic acid) film having a molecular orientation, and a touch input device using the touch panel have been also known (for example, refer to International Publication No. WO 2010/143528).
Further, a linear polarizer is occasionally used for a display device, such as a liquid crystal display device and an organic electroluminescent display device (for example, refer to JP-A No. 2006-268018, JP-A No. 2009-192611, and JP-A No. 2009-21408).

SUMMARY OF INVENTION

Technical Problem

An adhesive surface layer for purpose of bonding with another member such as an electrode, or a protective surface layer for purpose of protection may be sometimes provided on a crystalline polymeric piezoelectric body.
However, when such a surface layer is formed, the piezoelectric constant of a layered body composed of the crystalline polymeric piezoelectric body and the surface layer tends to decrease.
Further, a surface layer formed so as to contact at least a part of a crystalline polymeric piezoelectric body may occasionally peel therefrom. Therefore, further improvement of adherence between a crystalline polymeric piezoelectric body and a surface layer has been desired.
Consequently, an object of the first aspect of the present invention is to provide a layered body, in which decrease in sensitivity is suppressed.
Further, an object of the second aspect of the present invention is to provide a layered body superior in adherence between a crystalline polymeric piezoelectric body and a surface layer.

Solution to Problem

The first aspect of the invention is a layered body according to the following [1]. The second aspect of the invention is a layered body according to the following [6]. The scope of the first aspect and the scope of the second aspect may overlap.
[1] A layered body comprising: a crystalline polymeric piezoelectric body having a molecular orientation, and a surface layer in which a relationship between a tensile modulus Ec (GPa) and a thickness d (μm) satisfies the following Formula (A):

$$0.6 \leq Ec / d \qquad \text{Formula (A).}$$

[2] The layered body according to [1], wherein Ec / d in Formula (A) is 36 or less.
[3] The layered body according to [1] or [2], wherein the thickness d of the surface layer is from 0.01 μm to 10 μm.
[4] The layered body according to any one of [1] to [3], wherein the tensile modulus Ec of the surface layer is from 0.1 GPa to 1,000 GPa.
[5] The layered body according to any one of [1] to [4], wherein the surface layer comprises at least one kind of

material selected from the group consisting of an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acrylic hybrid compound, a silica-epoxy hybrid compound, a metal, and a metallic oxide.

[6] A layered body comprising: a crystalline polymeric piezoelectric body, a standardized molecular orientation MORc of the crystalline polymeric piezoelectric body, measured by a microwave transmission molecular orientation meter based on a reference thickness of 50 μm, being from 2.0 to 10.0; and a surface layer placed so that at least a part thereof contacts the crystalline polymeric piezoelectric body, and comprising a carbonyl group and a polymeride.

The layered body according to [6] is preferably a layered body according to any one of [1] to [5]. Namely, for a layered body according to any one of [1] to [5], it is preferable that the standardized molecular orientation MORc of the crystalline polymeric piezoelectric body, measured by a microwave transmission molecular orientation meter based on a reference thickness of 50 μm, is from 2.0 to 10.0, and that the surface layer is placed so that at least a part thereof contacts the crystalline polymeric piezoelectric body, and comprises a carbonyl group and a polymeride.

[7] The layered body according to any one of [1] to [6], wherein the surface layer comprises a material having a three-dimensionally cross-linked structure.

[8] The layered body according to any one of [1] to [7], wherein an internal haze for visible light of the crystalline polymeric piezoelectric body is 50% or less, and wherein a piezoelectric constant $d_{14}$ of the crystalline polymeric piezoelectric body measured at 25°C by a stress-electric charge method is 1 pC/N or more.

[9] The layered body according to any one of [1] to [8], wherein an internal haze of the crystalline polymeric piezoelectric body with respect to visible light is 13% or less.

[10] The layered body according to any one of [1] to [9], wherein a product of a standardized molecular orientation MORc of the crystalline polymeric piezoelectric body measured by a microwave transmission molecular orientation meter based on a reference thickness of 50 μm and a crystallinity of the crystalline polymeric piezoelectric body measured by a DSC method is from 40 to 700.

[11] The layered body according to any one of [1] to [10], wherein the crystalline polymeric piezoelectric body comprises a polymer (preferably, a helical chiral polymer having optical activity) including a repeating unit structure having at least one functional group of a carbonyl group or an oxy group.

[12] The layered body according to any one of [1] to [11], wherein the crystalline polymeric piezoelectric body comprises a helical chiral polymer having optical activity with a weight-average molecular weight of from 50,000 to 1,000,000, and has a crystallinity measured by a DSC method of from 20% to 80%.

[13] The layered body according to [12], wherein the helical chiral polymer is a poly(lactic acid)-type polymer having a main chain including a repeating unit represented by the following Formula (1):

[14] The layered body according to [12] or [13], wherein an optical purity of the helical chiral polymer is 95.00%ee or more.

[15] The layered body according to any one of [12] to [14], wherein a content of the helical chiral polymer in the crystalline polymeric piezoelectric body is 80 mass % or more.

[16] The layered body according to any one of [12] to [15], wherein the crystalline polymeric piezoelectric body contains a stabilizer with a weight-average molecular weight of from 200 to 60,000 having at least one kind of functional group selected from the group consisting of a carbodiimide group, an epoxy group, and an isocyanate group, and wherein the stabilizer is contained at from 0.01 part by mass to 10 parts by mass with respect to 100 parts by mass of the helical chiral polymer.

[17] The layered body according to [16], wherein the stabilizer has a functional group selected from the group consisting of a carbodiimide group, an epoxy group, and an isocyanate group, in a molecule.

[18] The layered body according to [6], wherein the polymeride is a polymeride of a compound having a (meth)acrylic group.

[19] The layered body according to [6] or [18], wherein the polymeride is an active energy ray curable resin cured by irradiation with an active energy ray.

In the layered body according to [6], [18], or [19], the polymeride is preferably an ultraviolet curable resin cured by irradiation with ultraviolet light.

[20] The layered body according to any one of [1] to [19], wherein a ratio of acrylic terminals of a polymer contained in the crystalline polymeric piezoelectric body, which is determined by measuring a $^{1}$H-NMR spectrum with respect to a solution obtained by dissolving 20 mg of the crystalline polymeric piezoelectric body in 0.6 mL of deuterated chloroform and calculating a ratio of acrylic terminals of the polymer by the following Formula (X) based on the measured $^{1}$H-NMR spectrum, is from $2.0\times10^{-5}$ to $10.0\times10^{-5}$:

$$\text{Ratio of acrylic terminals of the polymer} = \text{Integral value of peak derived from acrylic terminals of the polymer} / \text{Integral value of peak derived from methine groups in main chains of the polymer} \qquad \text{Formula (X).}$$

Advantageous Effects of Invention

According to the first aspect of the invention, a layered body in which decrease in the sensitivity is suppressed can be provided.
According to the second aspect of the invention, a layered body superior in adhesion between a crystalline polymeric piezoelectric body and a surface layer can be provided.

BRIEF DESCRIPTION OF DRAWINGS

Fig. 1 is a graph showing a relationship between Ec / d and sensitivity change in Examples 1A to 7A and Comparative Examples 1A and 2A.
Fig. 2 is a graph showing an Ec / d range of from 0 to 1.5 in Fig. 1.
Fig. 3 is a schematic diagram showing a cutting out direction of a specimen for measurement of tear strength in Examples 15B to 21B.

DESCRIPTION OF EMBODIMENTS

<First aspect>

A layered body according to the first aspect of the invention includes a crystalline polymeric piezoelectric body having a molecular orientation, and a surface layer. In the surface layer, a relationship between a tensile modulus Ec (GPa) and a thickness d (μm) satisfies the following Formula (A):

$$0.6 \leq Ec / d \qquad \text{Formula (A)}$$

On the crystalline polymeric piezoelectric body (hereinafter also referred to simply as "piezoelectric body"), an adhesive surface layer for purpose of bonding with another member such as an electrode, or a protective surface layer for purpose of protection may be occasionally provided. However, when such a surface layer is formed, the piezoelectric constant of a layered body including the crystalline polymeric piezoelectric body and a surface layer tends to decrease.
Meanwhile, according to the first aspect, by regulating the relationship between the thickness d and the tensile modulus Ec in the surface layer into a range satisfying the Formula (A), decrease in the sensitivity of the piezoelectric body can be suppressed.

[Surface layer]

The surface layer in the first aspect means a layer existing on a surface of the piezoelectric body. Therefore, another member may be placed on the surface layer, and the surface layer may not necessarily be the outermost layer of a final formed article. Incidentally, examples of such other members to be placed on the surface layer of the layered body including the piezoelectric body and the surface layer include an electrode. The electrode may be an electrode which covers all the surface layer, or an electrode pattern constituted to cover only a part of the surface layer.
Further, the surface layer in the first aspect may be constituted with a single layer or a multilayer film layering plural functional layers. Further, the surface layer in the first aspect may be present not only on a single side of the piezoelectric body but on both the sides, and the two may have different functions, or use different materials.

Formula (A)

The surface layer in the first aspect satisfies Formula (A). When the ratio of a tensile modulus Ec to a thickness d (Ec / d) satisfies the Formula, decrease in the sensitivity of the piezoelectric body of the layered body can be suppressed.

In this regard, the ratio (Ec / d) is more preferably 1.0 or more, further preferably 1.4 or more, and still further preferably 3 or more.

Although there is no particular upper limit of the ratio (Ec / d), the ratio (Ec / d) is preferably 36 or less. The ratio (Ec / d) is more preferably 30 or less, further preferably 25 or less, and still further preferably 17.72 or less.

The ratio (Ec / d) is especially preferably from 1.4 to 17.72.

Tensile modulus Ec of surface layer

Although there is no particular restriction on the tensile modulus Ec of the surface layer, a range of from 0.1 GPa to 1,000 GPa is preferable.

When the tensile modulus Ec is not less than the lower limit, decrease in the tensile modulus of the layered body can be suppressed. Meanwhile, when the tensile modulus Ec is not more than the upper limit, the layered body can be deformed by an ordinary human force, so that the same can be utilized as a sensor.

The upper limit of the tensile modulus Ec is more preferably 300 GPa or less, and further preferably 100 GPa or less. The lower limit is more preferably 1 GPa or more, and further preferably 2 GPa or more.

Since a surface layer in the first aspect is some times a very thin layer, it may be in such a case difficult to measure directly the tensile modulus of a lone surface layer. Consequently, the tensile modulus Ec of the surface layer is calculated hereunder according to the following formula.

Tensile modulus Ec of surface layer = [Tensile modulus of layered body – (Tensile modulus of lone piezoelectric body × Thickness of piezoelectric body / Thickness of layered body)] / (Thickness of surface layer / Thickness of layered body)

In this regard, in a case in which the surface layer is a multilayer film composed of plural functional layers, the tensile modulus Ec expresses an average tensile modulus of an entire multilayer film. Further, in a case in which surface layers are present on both sides of the piezoelectric body, the tensile modulus Ec expresses an average tensile modulus of entire surface layers on both sides.

The "tensile modulus of layered body" in the above formula is measured by the following method.

The layered body is cut into a length of 120 mm in a direction 45° to the stretching direction (for example, MD direction) of the crystalline polymeric piezoelectric body, and into a length of 10 mm in a direction perpendicular to the 45° direction, to prepare a rectangular sample.

The obtained sample is set on a tensile testing machine (TENSILON RTG-1250, produced by A&D Company Ltd.) in which a distance between chucks is set to 70 mm so as not to loosen. A force is applied cyclically at a crosshead speed of 5 mm/min such that the applied force reciprocates between 4N and 9N to obtain a stress-strain relationship. From the obtained stress-strain relationship, a tensile modulus E is calculated.

$$\sigma = F/A$$

$$E = \Delta\sigma/\Delta\varepsilon$$

[$\sigma$: stress (Pa), F: applied force (N), A: cross section of layered body ($m^2$), $\Delta\sigma$: change in stress (Pa), and $\Delta\varepsilon$: change in strain]

The "Tensile modulus of lone piezoelectric body" is measured in the same manner as the tensile modulus of the layered body after preparing a sample by removing the surface layer from the layered body, or preparing the same piezoelectric body as the piezoelectric body in the layered body.

The tensile modulus Ec of the surface layer is regulated, for example, by selecting a material constituting the surface layer. For example, when a material constituting the surface layer contains a cured product of a curable compound, by decreasing the equivalent of a polymerizable functional group in a curable compound (namely, by increasing the number of polymerizable functional groups contained in the curable compound per unit molecular weight), the crosslink density can be enhanced and the tensile modulus Ec can be increased.

Thickness d

Although there is no particular restriction on a thickness (average thickness) d of the surface layer, a range of

from 0.01 μm to 10 μm is preferable.

When the thickness d is not below the lower limit, the surface layer exhibits, for example, a function as a hard coat layer described below.

Meanwhile, when the thickness d is not above the upper limit, in a case in which an electrode is provided further on the surface layer of the layered body, a larger electric charge is generated at the electrode.

The upper limit of the thickness d is more preferably 6 μm or less, and further preferably 3 μm or less. The lower limit is more preferably 0.2 μm or more, and further preferably 0.3 μm or more.

However, in a case in which the surface layer is a multilayer film constituted with plural functional layers, the thickness d represents the thickness of the entire multilayer film. Further, surface layers may be present on both sides of the piezoelectric body, and in this case the thickness d represents the total thickness of the two.

The thickness d of the surface layer is determined using a digital length measuring machine (DIGIMICRO STAND MS-11C, produced by Nikon Corporation) according to the following formula.

$$d = dt\text{-}dp \qquad \text{Formula}$$

wherein dt: Ten point average thickness of the layered body

dp: Ten point average thickness of the piezoelectric body before formation of the surface layer or after removal of the surface layer

Kind (use) of surface layer

Examples of the surface layer to be formed on a surface of the piezoelectric body include various functional layers. Examples of functional layers include an easy adhesive layer, a hard coat layer, a refractive index adjusting layer, an anti-reflection layer, an anti-glare layer, an easily slidable layer, an anti-blocking layer, a protection layer, an adhesive layer, a sticking layer, an anti-static layer, a heat dissipation layer, an ultraviolet light absorption layer, an anti-Newton ring layer, a light scattering layer, a polarization layer, a gas barrier layer, and a hue adjustment layer.

On the layered body layering the piezoelectric body and a surface layer, another member may be placed on the surface layer, and examples of such another member include an electrode. In an exemplary embodiment where an electrode is provided, as the surface layer especially a functional layer, such as an easy adhesive layer, a hard coat layer, and a refractive index adjusting layer, is generally provided.

When a surface layer is formed, there is also an effect that a defect on the piezoelectric body surface, such as a die line or a bruise, is covered, so as to improve the appearance. In this case, when the refractive index difference between the piezoelectric body and a surface layer is smaller, reflection at an interface between the piezoelectric body and a surface layer is decreased and the appearance can be further improved.

Material

Although there is no particular restriction on a material of the surface layer, it should preferably include at least one kind of material selected from the group consisting of an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acrylic hybrid compound, a silica-epoxy hybrid compound, a metal, and a metallic oxide.

Among them, an acrylic compound, an epoxy compound, a silane compound, and a metallic oxide are more preferable.

Formation method (wet coating method)

As a method for forming a surface layer, a heretofore widely used publicly known method can be used appropriately, and there is for example a wet coating method. For example, a surface layer is formed by coating a coating liquid dispersing or dissolving a material, such as an acrylic compound, a methacrylic compound, a vinyl compound, an allyl compound, an urethane compound, an epoxy compound, an epoxide compound, a glycidyl compound, an oxetane compound, a melamine compound, a cellulose compound, an ester compound, a silane compound, a silicone compound, a siloxane compound, a silica-acrylic hybrid compound, and a silica-epoxy hybrid compound.

If necessary, the thus coated material (a curable compound) is heated or irradiated with an active energy ray (ultraviolet light, electron beam, radiation, *etc.*) to cure a surface layer. When a surface layer contains a cured product

of a curable compound as above, by decreasing the equivalent of a polymerizable functional group in a curable compound (namely, by increasing the number of polymerizable functional groups contained in the curable compound per unit molecular weight), the crosslink density can be enhanced and the tensile modulus Ec can be increased.

As a material to be contained in a surface layer, among the cured products, an active energy ray curable resin cured by irradiation with an active energy ray (ultraviolet light, electron beam, radiation, *etc.*) is preferable. By inclusion of an active energy ray curable resin, the production efficiency is improved, and decrease in the performance of the piezoelectric body caused by formation of a surface layer can be suppressed.

Further, as a material to be contained in a surface layer, among the cured products, a cured product having a three-dimensional cross-linked structure is preferable. By inclusion of a cured product having a three-dimensional cross-linked structure, the crosslink density is enhanced and the tensile modulus Ec can be increased.

As a production means for a cured product having a three-dimensional cross-linked structure, there are a method using a monomer having 3 or more polymerizable functional groups (tri- or higher functional monomer) as a curable compound, a method using a cross-linking agent having 3 or more polymerizable functional groups (tri- or higher functional cross-linking agent), *etc.* as well as a method using a cross-linking agent such as an organic peroxide as a cross-linking agent. The means may be used in a combination of two or more thereof.

Examples of a tri- or higher functional monomer include a (meth)acrylic compound having 3 or more (meth)acrylic groups in a molecule, and an epoxy compound having 3 or more epoxy groups in a molecule.

A "(meth)acrylic group" represents herein at least one of an acrylic group or a methacrylic group.

Further, "to have 3 or more (meth)acrylic groups in a molecule" means that a molecule has at least one of an acrylic group or a methacrylic group, and the total number of the acrylic group and methacrylic group in a molecule is 3 or more.

In this regard, as a method for confirming whether a material contained in a surface layer is a cured product having a three-dimensional cross-linked structure or not, there is for example a method to measure a gel fraction.

Specifically, a gel fraction can be derived from an insoluble obtained after dipping a surface layer in a solvent for 24 hours. In either case, in which a solvent is a hydrophilic solvent such as water, or a lipophilic solvent such as toluene, if a gel fraction is beyond a certain level, it may be presumed that the material has a three-dimensional cross-linked structure.

As for a use of a surface layer by a wet coating method, it may be applied to any of the listed layers. In the case of a wet coating method, a coating liquid may be coated on to a web of the piezoelectric body before stretching and thereafter the piezoelectric body is stretched, or a coating liquid may be coated on to an already stretched web of the piezoelectric body.

The thickness of a (single layer) surface layer by a wet coating method is preferably in a range of several tens of nm to 10 $\mu$m.

Further, according to a purpose, various organic substances, and inorganic substances, such as a refractive index adjuster, an UV absorber, a leveling agent, an antistatic agent, and an anti-blocking agent, may be added to a surface layer.

Formation method (dry coating method)

As a formation method of a surface layer, there is also a dry coating method. Examples thereof include a vacuum deposition method, a sputtering method, an ion plating method, and a CVD method, which are favorably applicable to formation of a metal film, a metallic oxide film, *etc.* Examples of uses of a surface layer by a dry coating method include an easy adhesive layer, a refractive index adjusting layer, and an anti-reflection layer. The thickness of a (single layer) surface layer by a dry coating method is preferably in a range of several tens of nm to several hundreds of nm.

Surface treatment

A surface of the piezoelectric body may be treated by a corona treatment or an Itro treatment, an ozone treatment, a plasma treatment, or the like from viewpoints of improvement of adherence between the piezoelectric body surface and a surface layer, or a coating property of a surface layer on to a surface of the piezoelectric body.

Relative dielectric constant

The relative dielectric constant of a surface layer is preferably 1.5 or more, more preferably from 2.0 to 20,000, and further preferably from 2.5 to 10,000.

When the relative dielectric constant is in the range, in a case in which an electrode is provided further on the surface layer of the layered body, a larger electric charge is generated at the electrode.

The relative dielectric constant of a surface layer is measured by the following method.

After a surface layer is formed on a single side of the piezoelectric body, an approx. 50 nm-thick A1 is deposited on both sides of the layered body using SIP-600 from Showa Shinku Co., Ltd. A piece of film in a size of 50 mm×50 mm is sliced out of the layered body. The specimen is connected with an LCR METER 4284A (produced by Hewlett-Packard Company) to measure the capacitance C, and the relative dielectric constant εc of a surface layer is calculated according to the following formula.

$$\varepsilon c = (C\times d\times 2.7) / (\varepsilon_0\times 2.7\times S - C\times dp)$$

d: surface layer thickness, $\varepsilon_0$: vacuum dielectric constant, S: specimen area, and dp: piezoelectric body thickness.

Internal haze of surface layer

The internal haze of the surface layer is preferably 10% or less, more preferably from 0.0% to 5%, and further preferably from 0.01% to 2%.
When the internal haze is in the range, the surface layer exhibits superior transparency, and is effectively applicable, for example, to a touch panel.
The internal haze of a surface layer is calculated according to the following formula.

$$Hc = H - Hp$$

H: internal haze of layered body
Hp: internal haze of piezoelectric body before formation of surface layer or after removal of surface layer

wherein the internal haze of the piezoelectric body is a value measured by measuring the crystalline polymeric piezoelectric body with a thickness of from 0.03 mm to 0.05 mm at 25°C with a haze meter (TC-H III DPK, produced by Tokyo Denshoku Co., Ltd.) according to JIS-K7105. The measuring method will be described in detail in an Example.
The internal haze of the layered body is measured similarly to the measuring method of the internal haze of the piezoelectric body.
A surface layer in the first aspect as described above may correspond to a surface layer in the second aspect described below.
For example, a surface layer in the first aspect may contain a carbonyl group (-C(=O)-) as well as a polymeride.
Further, the polymeride may have a three-dimensional cross-linked structure.
Further, the polymeride may be a polymeride of a compound having a (meth)acrylic group.
Further, the polymeride may be an active energy ray curable resin cured by irradiation with an active energy ray (for example, an ultraviolet curable resin cured by irradiation with ultraviolet light).
The details of a surface layer in the second aspect will be described below.

[Crystalline polymeric piezoelectric body]

As the crystalline polymeric piezoelectric body (piezoelectric body) in the first aspect, a heretofore known crystalline polymeric piezoelectric body can be used without particular restriction.
Especially an example of the crystalline polymeric piezoelectric body containing a helical chiral polymer having optical activity, which is favorably used for the first aspect, will be described below.

[Helical chiral polymer having optical activity]

A helical chiral polymer having optical activity refers to a polymer having a helical molecular structure and having molecular optical activity.
The "helical chiral polymer having optical activity" is herein also referred to as "optically active polymer".
Examples of the optically active polymer include polypeptide, cellulose, a cellulose derivative, a poly(lactic acid)-type polymer, poly(propylene oxide), and poly(β-hydroxybutyric acid). Examples of the polypeptide include poly(γ-benzyl glutarate), and poly(γ-methyl glutarate). Examples of the cellulose derivative include cellulose acetate, and cyanoethyl cellulose.
The optical purity of the optically active polymer is preferably 95.00%ee or higher, more preferably 99.00%ee or higher, further preferably 99.99%ee or higher, and desirably 100.00%ee. It is presumed that, by selecting the optical

purity of the optically active polymer in the above range, packing of a polymer crystal exhibiting piezoelectricity becomes denser and as a result the piezoelectricity is increased.

The optical purity of the optically active polymer in the first aspect is a value calculated according to the following formula:

$$\text{Optical purity (\%ee)} = 100\times|\text{L-form amount - D-form amount}| / (\text{L-form amount + D-form amount})$$

Namely, a value of "the difference (absolute value) between L-form amount [mass %] of the optically active polymer and D-form amount [mass %] of the optically active polymer" divided by "the total of L-form amount [mass %] of the optically active polymer and D-form amount [mass %] of the optically active polymer" multiplied by "100" is defined as optical purity.

In this regard, for the L-form amount [mass %] of the optically active polymer and the D-form amount [mass %] of the optically active polymer, values to be measured by a method using high performance liquid chromatography (HPLC) are used. Specific particulars with respect to a measurement will be described below.

Among the above optically active polymers, a polymer with the main chain including a repeating unit represented by the following Formula (1) is preferable from a viewpoint of enhancement of the optical purity and improvement of the piezoelectricity.

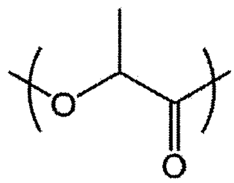

(1)

As an example of a polymer with the main chain including a repeating unit represented by the Formula (1) is named as a poly(lactic acid)-type polymer. Among others poly(lactic acid) is preferable, and a homopolymer of L-lactic acid (PLLA) or a homopolymer of D-lactic acid (PDLA) is most preferable.

The poly(lactic acid)-type polymer means "poly(lactic acid)", "a copolymer of L-lactic acid or D-lactic acid with a copolymerizable multi-functional compound", or a mixture of the two. The "poly(lactic acid)" is a polymer linking lactic acid by polymerization through ester bonds into a long chain, and it is known that poly(lactic acid) can be produced by a lactide method *via* lactide, a direct polymerization method, by which lactic acid is heated in a solvent under a reduced pressure for polymerizing while removing water, or the like. Examples of the "poly(lactic acid)" include a homopolymer of L-lactic acid, a homopolymer of D-lactic acid, a block copolymer including a polymer of at least one of L-lactic acid and D-lactic acid, and a graft copolymer including a polymer of at least one of L-lactic acid and D-lactic acid.

Examples of the "copolymerizable multi-functional compound" include a hydroxycarboxylic acid, such as glycolic acid, dimethyl glycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, and mandelic acid; a cyclic ester, such as glycolide, β-methyl-δ-valerolactone, γ-valerolactone, and ε-caprolactone; a polycarboxylic acid, such as oxalic acid, malonic acid, succinic acid, glutaric acid, adipic acid, pimelic acid, azelaic acid, sebacic acid, undecanedioic acid, dodecanedioic acid, and terephthalic acid, and an anhydride thereof; a polyhydric alcohol, such as ethyleneglycol, diethyleneglycol, triethyleneglycol, 1,2-propanediol, 1,3-propanediol, 1,3-butanediol, 1,4-butanediol, 2,3-butanediol, 1,5-pentanediol, 1,6-hexanediol, 1,9-nonanediol, 3-methyl-1,5-pentanediol, neopentylglycol, tetramethyleneglycol, and 1,4-hexanedimethanol; a polysaccharide such as cellulose; and an aminocarboxylic acid such as α-amino acid.

Examples of the "copolymer of L-lactic acid or D-lactic acid with a copolymerizable multi-functional compound" include a block copolymer or a graft copolymer having a poly(lactic acid) sequence, which can form a helical crystal.

The concentration of a structure derived from a copolymer component in the optically active polymer is preferably 20 mol % or less. For example, when the optically active polymer is a poly(lactic acid)-type polymer, with respect to the total number of moles of a structure derived from lactic acid and a structure derived from a compound copolymerizable with lactic acid (copolymer component) in the poly(lactic acid)-type polymer, the copolymer component is preferably 20 mol% or less.

The optically active polymer (for example, poly(lactic acid)-type polymer) can be produced, for example, by a method for yielding the polymer by direct dehydration condensation of lactic acid, as described in JP-A-S59-096123 and

JP-A-H7-033861, or a method for yielding the same by a ring-opening polymerization of lactide, which is a cyclic dimer of lactic acid, as described in U.S. Patents No. 2,668,182 and No. 4,057,357.

Further, in order to make the optical purity of the optically active polymer (for example, poly(lactic acid)-type polymer) yielded by any of the production methods to 95.00%ee or higher, for example, when a poly(lactic acid) is produced by a lactide method, it is preferable to polymerize lactide, whose optical purity has been enhanced to 95.00%ee or higher by a crystallization operation.

[Weight-average molecular weight of optically active polymer]

The weight-average molecular weight (Mw) of the optically active polymer in the first aspect is preferably from 50,000 to 1,000,000. When the lower limit of the weight-average molecular weight (Mw) of the optically active polymer is 50,000 or higher, the mechanical strength of a molding from the optically active polymer becomes sufficient. The lower limit of the weight-average molecular weight of the optically active polymer is preferably 100,000 or higher, and more preferably 150,000 or higher. Meanwhile, when the upper limit of the weight-average molecular weight of the optically active polymer is 1,000,000 or less, molding of the optically active polymer (for example, forming to a film by extrusion molding, *etc.)* can be performed easily. The upper limit of the weight-average molecular weight is preferably 800,000 or less, and more preferably 300,000 or less.

Further, the molecular weight distribution (Mw/Mn) of the optically active polymer is preferably from 1.1 to 5, more preferably from 1.2 to 4, and further preferably from 1.4 to 3, from a viewpoint of the strength of the crystalline polymeric piezoelectric body. The weight-average molecular weight Mw and the molecular weight distribution (Mw/Mn) of a poly(lactic acid)-type polymer are measured using a gel permeation chromatograph (GPC) by the following GPC measuring method.

- GPC measuring apparatus: GPC-100 produced by Waters Corp.
- Column: SHODEX LF-804 produced by Showa Denko K.K.
- Preparation of sample: A poly(lactic acid)-type polymer is dissolved in a solvent (e.g. chloroform) at 40°C to prepare a sample solution with the concentration of 1 mg/mL.
- Measurement condition: A sample solution 0.1 mL is introduced into a column at a temperature of 40°C and a flow rate of 1 mL/min by using chloroform as a solvent.

The sample concentration in the sample solution separated by the column is measured by a differential refractometer. Based on polystyrene standard samples, a universal calibration curve is created and the weight-average molecular weight (Mw) and the molecular weight distribution (Mw/Mn) of a poly(lactic acid)-type polymer are calculated based on the created universal calibration curve.

For a poly(lactic acid)-type polymer, a commercial poly(lactic acid) may be used. Examples of a commercial poly(lactic acid) include PURASORB (PD, PL) produced by Purac Corporate, LACEA (H-100, H-400) produced by Mitsui Chemicals, Inc., and INGEO 4032D, 4043D, *etc.* produced by NatureWorks LLC.

When a poly(lactic acid)-type polymer is used as the optically active polymer and in order to make the weight-average molecular weight (Mw) of the poly(lactic acid)-type polymer 50,000 or higher, it is preferable to produce the optically active polymer by a lactide method, or a direct polymerization method.

The crystalline polymeric piezoelectric body in the first aspect may contain only a single kind of the above optically active polymers, or two or more kinds of the same.

Although there is no particular restriction on the content of the optically active polymer (if 2 or more kinds are present, the total content) in the crystalline polymeric piezoelectric body in the first aspect, 80 mass % or more with respect to the total mass of the crystalline polymeric piezoelectric body is preferable.

When the content is 80 mass % or more, the piezoelectric constant tends to grow larger.

[Other components]

The crystalline polymeric piezoelectric body in the first aspect may contain components other than the aforedescribed optically active polymers (for example, publicly known resins, as represented by poly(vinylidene fluoride), a polyethylene resin and a polystyrene resin, inorganic fillers, such as silica, hydroxyapatite, and montmorillonite, and publicly known crystal nucleating agents such as phthalocyanine).

Further, from a viewpoint of better inhibition of a structural change by hydrolysis, *etc.* the crystalline polymeric piezoelectric body in the first aspect should preferably contain a stabilizer such as a carbodiimide compound as represented by CARBODILITE (registered trade mark).

- Inorganic filler -

The crystalline polymeric piezoelectric body in the first aspect may contain at least one kind of inorganic filler.

For example, in order to form the crystalline polymeric piezoelectric body to a transparent film inhibiting generation of a void such as an air bubble, an inorganic filler such as hydroxyapatite may be nano-dispersed into the crystalline polymeric piezoelectric body. However for nano-dispersing the inorganic filler, large energy is required to disintegrate an aggregate, and when the inorganic filler is not nano-dispersed, the film transparency may occasionally be compromised. Therefore, when the crystalline polymeric piezoelectric body in the first aspect contains an inorganic filler, the content of the inorganic filler with respect to the total mass of the crystalline polymeric piezoelectric body is preferably less than 1 mass %.

Further, when the crystalline polymeric piezoelectric body contains components other than the optically active polymer, the content of the components other than the optically active polymer is preferably 20 mass % or less, and more preferably 10 mass % or less with respect to the total mass of the crystalline polymeric piezoelectric body.

- Crystallization accelerator (crystal nucleating agent) -

The crystalline polymeric piezoelectric body in the first aspect may contain at least one kind of crystallization accelerator (crystal nucleating agent).

Although there is no particular restriction on a crystallization accelerator (crystal nucleating agent) insofar as a crystallization accelerating effect can be recognized, it is preferable to select a substance with the crystal structure having lattice spacing close to the lattice spacing of the crystal lattice of the optically active polymer. This is because a substance having closer lattice spacing has the higher activity as a nucleating agent. For example, when the poly(lactic acid)-type resin is used as the optically active polymer, examples include an organic substance, such as zinc phenylsulfonate, melamine polyphosphate, melamine cyanurate, zinc phenylphosphonate, calcium phenylphosphonate, and magnesium phenylphosphonate, and an inorganic substance, such as talc and clay. Among others, zinc phenylphosphonate, which has lattice spacing closest to the lattice spacing of poly(lactic acid) and exhibits excellent crystallization accelerating activity, is preferable. Meanwhile, a commercial product can be used as a crystallization accelerator. Specific examples thereof include ECOPROMOTE (zinc phenylphosphonate: produced by Nissan Chemical Ind., Ltd.).

The content of a crystal nucleating agent with respect to 100 parts by mass of the optically active polymer is normally from 0.01 to 1.0 part by mass, preferably from 0.01 to 0.5 part by mass, and from a viewpoint of better crystallization accelerating activity and maintenance of a biomass ratio especially preferably from 0.02 to 0.2 part by mass.

When the content of a crystal nucleating agent is 0.01 part by mass or more, the crystallization accelerating effect can be attained more effectively. When the content of a crystal nucleating agent is less than 1.0 part by mass, the crystallization speed can be regulated more easily.

The crystalline polymeric piezoelectric body preferably does not contain a component other than a helical chiral polymer having optical activity (optically active polymer) from a viewpoint of transparency.

- Stabilizer -

The crystalline polymeric piezoelectric body in the first aspect may contain a stabilizer.

A stabilizer to be used in the first aspect is a compound with a weight-average molecular weight of from 200 to 60,000 having at least one kind of functional group selected from the group consisting of a carbodiimide group, an epoxy group, and an isocyanate group. The stabilizer is used for inhibiting hydrolysis of the optically active polymer so as to improve the moist heat resistance of a product piezoelectric body.

For the sake of inhibiting hydrolysis of an aliphatic polyester such as the optically active polymer, many methods have been known including a method of reducing a low molecular weight compound, such as an unreacted monomer, impurities, and an open-chain or cyclic oligomer, in a polymer such as polyester (e.g. JP-A-H9-12688); a method of adding an aromatic carbodiimide (e.g. Japanese National Publication of International Patent Application No. 2001-525473); a method of adding an oxazoline compound (e.g. JP-A-2007-77193); and the like.

However, a method for improving the reliability of the piezoelectric body containing the optically active polymer, by inhibiting hydrolysis of the optically active polymer contained in the piezoelectric body, and without compromising significantly the piezoelectric properties and transparency, has not been yet known.

The inventors found through investigation that by adding in a specific amount a stabilizer having a specific functional group to the optically active polymer, the moist heat resistance and the reliability of the piezoelectric body can be improved by inhibiting hydrolysis of the optically active polymer without compromising significantly the piezoelectric properties and transparency.

Examples of a specific functional group that can interact with both a hydroxy group and a carboxy group include at least 1 kind of functional group selected from the group consisting of a carbodiimide group, an isocyanate group, and

an epoxy group having the following structures, and among others a carbodiimide group is preferable from a viewpoint of effectiveness.

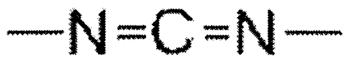

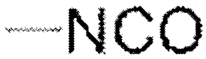

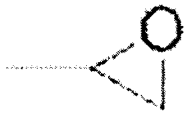

The weight-average molecular weight of a stabilizer used in the current embodiment is preferably from 200 to 60,000, more preferably from 200 to 30,000, and further preferably from 300 to 18,000. It is presumed that, when the molecular weight is within the above range, a stabilizer can move easily as described in the above action, and an improving effect on moist heat resistance can be attained sufficiently.

The weight-average molecular weight of the stabilizer is especially preferably from 200 to 900. In this connection, the weight-average molecular weight of from 200 to 900 is almost the same as a number average molecular weight of from 200 to 900. Especially, when the weight-average molecular weight is from 200 to 900, the molecular weight distribution is occasionally 1.0. In this case the "weight-average molecular weight of from 200 to 900" may be reworded as "molecular weight of from 200 to 900".

(Carbodiimide compound)

A carbodiimide compound having a carbodiimide group to be used as a stabilizer in the first aspect has 1 or more carbodiimide groups in a molecule. As carbodiimide compounds (including a polycarbodiimide compound), those synthesized by a publicly known method can be used. Examples thereof include those synthesized from various isocyanates which are subjected to a decarboxylation condensation reaction without a solvent or in an inert solvent at a temperature of approx. 70°C or higher using an organic phosphorous compound or an organometallic compound as a catalyst.

Examples of a monocarbodiimide compound included in the carbodiimide compound include dicyclohexylcarbodiimide, dimethylcarbodiimide, diisobutylcarbodiimide, dioctylcarbodiimide, *t*-butylisopropylcarbodiimide, diphenylcarbodiimide, di-*t*-butylcarbodiimide, and di-β-naphthyl carbodiimide, and among others, especially from a standpoint of easy industrial availability, dicyclohexylcarbodiimide, or bis-2,6-diisopropylphenylcarbodiimide is appropriate.

As a polycarbodiimide compound included in the carbodiimide compound, products of various methods can be used. Products of heretofore known methods for producing polycarbodiimide (for example, U.S. Patent No. 2941956, Japanese Published Examined Application No. S47-33279, J. Org. Chem. 28, 2069-2075 (1963), Chemical Review 1981, Vol. 81, No. 4, p. 619-621) can be used. Specifically, a carbodiimide compound described in Japanese Patent No. 4084953 can be also used.

Examples of a polycarbodiimide compound include poly(4,4'-dicyclohexylmethanecarbodiimide), poly(tetramethylxylylenecarbodiimide), poly(*N,N*-dimethylphenylcarbodiimide), and poly(*N,N'*-di-2,6-diisopropylphenylcarbodiimide), and there is no particular restriction, insofar as a carbodiimide compound has such a function and 1 or more carbodiimide groups in a molecule.

As a carbodiimide compound a commercial product may be used, and examples thereof include B2756 (trade name) produced by Tokyo Chemical Industry Co., Ltd., CARBODILITE LA-1 produced by Nisshinbo Chemical Inc., and STABAXOL P, STABAXOL P400, and STABAXOL I (all are trade names) produced by Rhein Chemie Rheinau GmbH.

(Isocyanate compound)

Examples of a compound having an isocyanate group (isocyanate compound) to be used as a stabilizer in the first aspect include hexylisocyanate, cyclohexyl isocyanate, benzyl isocyanate, phenethyl isocyanate, butyl isocyanatoacetate, dodecyl isocyanate, octadecyl isocyanate, 3-(triethoxysilyl)propyl isocyanate, 2,4-tolylene diisocyanate, 2,6-tolylene diisocyanate, m-phenylene diisocyanate, *p*-phenylene diisocyanate, 4,4'-diphenylmethane diisocyanate, 2,4'-diphenylmethane diisocyanate, 2,2'-diphenylmethane diisocyanate, 3,3'-dimethyl-4, 4'-biphenylene diisocyanate, 3,3'-dimethoxy-4,4'-biphenylene diisocyanate, 3,3'-dichloro-4,4'-biphenylene diisocyanate, 1,5-naphthalene diisocyanate, 1,5-tetrahydronaphthalene diisocyanate, tetramethylene diisocyanate, 1,6-hexamethylene diisocyanate, dodecamethylene diisocyanate, trimethylhexamethylene diisocyanate, 1,3-cyclohexylene diisocyanate, 1,4-cyclohexylene diisocyanate, xylylene diisocyanate, tetramethylxylylene diisocyanate, hydrogenated xylylene diisocyanate, lysine diisocyanate, isophorone diisocyanate, 4,4'-dicyclohexylmethane diisocyanate, or 3,3'-dimethyl-4,4'-dicyclohexylmethane diisocyanate, diphenylmethane diisocyanate-type polyisocyanate, 1, 6-hexamethylene diisocyanate-type polyisocyanate, xylylenediisocyanate-type polyisocyanate, and isophoronediisocyanate-type polyisocyanate.

(Epoxy compound)

Examples of a compound having an epoxy group (epoxy compound) to be used as a stabilizer in the first aspect include *N*-glycidyl phthalimide, *ortho*-phenylphenyl glycidyl ether, phenyl glycidyl ether, *p-t*-butylphenyl glycidyl ether, hydroquinone diglycidyl ether, resorcinol diglycidyl ether, 1,6-hexanediol diglycidyl ether, diethyleneglycol diglycidyl ether, polyethylene glycol diglycidyl ether, trimethylolpropane triglycidyl ether, bisphenol A-diglycidyl ether, hydrogenated bisphenol A-diglycidyl ether, a phenol novolac-type epoxy resin, a cresol novolac-type epoxy resin, and an epoxidized polybutadiene.

Stabilizers related to the current embodiment may be used singly or in combination of 2 or more thereof. Examples of a preferable mode of a stabilizer include a mode, in which a stabilizer (B1) having at least one kind of functional group selected from the group consisting of a carbodiimide group, an epoxy group, and an isocyanate group, and having the number-average molecular weight of from 200 to 900, and a stabilizer (B2) having in a molecule 2 or more functional groups of 1 or more kinds selected from the group consisting of a carbodiimide group, an epoxy group, and an isocyanate group, and having the weight-average molecular weight of from 1,000 to 60,000 are used in combination. In this regard, the weight-average molecular weight of a stabilizer (B1) with the number-average molecular weight of from 200 to 900 is about from 200 to 900, and the number-average molecular weight and the weight-average molecular weight of a stabilizer (B1) give almost the same values.

Specific examples of a stabilizer (B1) include dicyclohexylcarbodiimide, bis-2,6-diisopropylphenylcarbodiimide, hexyl isocyanate, octadecyl isocyanate, 3-(triethoxysilyl)propyl isocyanate, *N*-glycidyl phthalimide, *ortho*-phenylphenyl glycidyl ether, phenyl glycidyl ether, and *p-t*-butylphenyl glycidyl ether.

While specific examples of a stabilizer (B2) include poly(4,4'-dicyclohexylmethane carbodiimide), poly(tetramethylxylylene carbodiimide), poly(*N,N*-dimethylphenylcarbodiimide), poly(*N,N*'-di-2,6-diisopropylphenylcarbodiimide), diphenylmethane diisocyanate-type polyisocyanate, a 1,6-hexamethylene diisocyanate-type polyisocyanate, a xylylene diisocyanate-type polyisocyanate, an isophorone diisocyanate-type polyisocyanate, a phenol novolac-type epoxy resin, a cresol novolac-type epoxy resin, and epoxidized polybutadiene.

By containing a stabilizer (B1) with a relatively low molecular weight and a multifunctional stabilizer (B2) with a relatively high molecular weight, especially moist heat resistance is improved. Regarding the balance between the added amounts of the two, a higher content of a stabilizer (B1), which is monofunctional and has a relatively low molecular weight, is preferable from a viewpoint of enhanced transparency, and the amount of a stabilizer (B2) with respect to 100 parts by mass of a stabilizer (B1) is preferably in a range of from 10 parts by mass to 150 parts by mass from a viewpoint of coexistence of transparency and moist heat resistance and more preferably in a range of from 50 parts by mass to 100 parts by mass.

Further, a mode in which a stabilizer contains a stabilizer (B3) having in a molecule a functional group selected from the group consisting of a carbodiimide group, an epoxy group, and an isocyanate group, is also a preferable mode from a viewpoint of enhancing the dimensional stability. Since a stabilizer (B3) contains in a molecule only one functional group selected from the group consisting of a carbodiimide group, an epoxy group, and an isocyanate group, a region of the optically active polymer having hydroxy groups and carboxy groups generated by hydrolysis interleaves the stabilizer (B3) and becomes hardly cross-linkable. As a result, presumably, molecular chains of the optically active polymer are flexibly displaced moderately to deconcentrate internal stress in the piezoelectric body so that the dimensional stability of the piezoelectric body is improved.

The weight-average molecular weight of a compound having in a molecule a functional group selected from the group consisting of a carbodiimide group, an epoxy group, and an isocyanate group is preferably from 200 to 2,000, more preferably from 200 to 1,500, and further preferably from 300 to 900.

Specific examples of a compound having in a molecule a functional group selected from the group consisting of a carbodiimide group, an epoxy group, and an isocyanate group include dicyclohexylcarbodiimide, bis-2,6-diisopropylphenylcarbodiimide, hexyl isocyanate, octadecyl isocyanate, 3-(triethoxysilyl)propyl isocyanate, *N*-glycidylphthalimide, *ortho*-phenylphenyl glycidyl ether, phenyl glycidyl ether, and *p-t*-butylphenyl glycidyl ether. Among them, dicyclohexylcarbodiimide and bis-2,6-diisopropylphenylcarbodiimide are preferable, and bis-2,6-diisopropylphenylcarbodiimide is further preferable.

A stabilizer (B3) and a stabilizer (B4) having in a molecule 2 or more functional groups selected from the group consisting of a carbodiimide group, an epoxy group, and an isocyanate group (for example, the stabilizer (B2) is included) may be used in combination. The amount of a stabilizer (B4) having in a molecule 2 or more functional groups selected from the group consisting of a carbodiimide group, an epoxy group, and an isocyanate group with respect to 100 parts by mass of a stabilizer (B3) is preferably in a range of from 5 parts by mass to 200 parts by mass, from a viewpoint of the balance among transparency, moist heat resistance and dimensional stability, and more preferably in a range of from 10 parts by mass to 100 parts by mass.

[Weight-average molecular weight and number-average molecular weight of stabilizer]

The number-average molecular weight (Mn) and the weight-average molecular weight (Mw) of the stabilizer are measured similarly by the measuring method using gel permeation chromatograph (GPC) as described in a section for the optically active polymer. They can be measured in addition to GPC by a measuring method, such as GC-MS, FAB-MS, ESI-MS, and TOF-MS.

The added amount of a stabilizer with respect to 100 parts by mass of the optically active polymer is preferably from 0.01 part by mass to 10 parts by mass. Further, in order to attain higher reliability (more specifically the reliability at 500 hours according to the reliability test) the added amount is more preferably 0.7 part by mass or more. Especially, when an aliphatic carbodiimide is used as a stabilizer, the content of from 0.01 part by mass to 2.8 parts by mass is further preferable from a viewpoint of transparency. When the added amount is in the above range, the reliability of the piezoelectric body can be enhanced without compromising significantly the internal haze of the piezoelectric body in the first aspect.

When 2 or more kinds of stabilizers are used in combination, the added amount refers to the total amount thereof.

Meanwhile, from a viewpoint of lowering internal haze and enhancing or maintaining the piezoelectric constant, the added amount of a stabilizer with respect to 100 parts by mass of the optically active polymer is preferably from 0.01 part by mass to 1.2 parts by mass, further preferably from 0.01 part by mass to 0.7 part by weight, and still further preferably from 0.01 part by mass to 0.6 part by mass.

[Structure]

As described below, in the crystalline polymeric piezoelectric body in the first aspect, a polymer (preferably, optically active polymer) is highly orientated. "Molecular orientation ratio MOR" is used as an index representing the orientation. Namely, the molecular orientation ratio (MOR) is a value indicating the degree of molecular orientation, and measured by the following microwave measurement method. Namely, a sample (film) is placed in a microwave resonant waveguide of a well known microwave molecular orientation ratio measuring apparatus (also referred to as a "microwave transmission-type molecular orientation meter") such that the sample plane (film plane) is arranged perpendicular to the travelling direction of the microwaves. Then, the sample is continuously irradiated with microwaves whose oscillating direction is biased unidirectionally, while maintaining such conditions, the sample is rotated in a plane perpendicular to the travelling direction of the microwaves from 0 to 360°, and the intensity of the microwaves passed through the sample is measured to determine the molecular orientation ratio MOR.

Standardized molecular orientation MORc in the first aspect means a MOR value to be measured at the reference thickness tc of 50 μm, and can be determined by the following formula.

$$\mathrm{MORc} = (\mathrm{tc}/\mathrm{t}) \times (\mathrm{MOR} - 1) + 1$$

(tc: Reference thickness corrected to; t: Sample thickness)

A standardized molecular orientation MORc can be measured by a publicly known molecular orientation meter, e.g. a microwave-type molecular orientation analyzer MOA-2012A or MOA-6000 produced by Oji Scientific Instruments, at a resonance frequency in the vicinity of 4 GHz or 12 GHz.

The standardized molecular orientation MORc can be regulated by crystallization conditions (heating temperature and heating time), and stretching conditions (stretching temperature and stretching speed) during production of the crystalline polymeric piezoelectric body.

Standardized molecular orientation MORc can be converted to birefringence Δn, which equals to retardation divided by the film thickness of the piezoelectric body.

More specifically, the retardation can be measured by an RETS 100, produced by Otsuka Electronics Co., Ltd. Further, MORc and Δn are approximately in a linearly proportional relationship, and if Δn is 0, MORc is 1.

<Physical properties of crystalline polymeric piezoelectric body >

The crystalline polymeric piezoelectric body in the first aspect has preferably a high piezoelectric constant (a piezoelectric constant $d_{14}$ measured by a stress-electric charge method at 25°C is preferably 1 pC/N or higher). Further, the crystalline polymeric piezoelectric body in the first aspect is preferably superior in transparency, and longitudinal tear strength (namely, tear strength in a specific direction; the same shall apply hereinbelow).

[Piezoelectric constant (stress-electric charge method)]

The piezoelectric constant of the crystalline polymeric piezoelectric body in the first aspect means a value measured as follows.

Firstly, the crystalline polymeric piezoelectric body is cut into a length of 150 mm in a direction 45° to the stretching direction of the crystalline polymeric piezoelectric body (for example, MD direction), and in the direction perpendicular to the 45° direction into a length of 50 mm, to prepare a rectangular specimen. Next, the obtained specimen is set on a stage of a SIP-600 from Showa Shinku Co., Ltd. and A1 is deposited on a side of the specimen to a deposited A1 thickness of approx. 50 nm. Then A1 was deposited similarly on the other side of the specimen. Thus, A1 electroconductive layers are formed on both the sides of the specimen.

A specimen (crystalline polymeric piezoelectric body) of 150 mm×50 mm with the A1 electroconductive layers on both sides is cut into a length of 120 mm in a direction 45° to the stretching direction (for example, MD direction) of the piezoelectric body and into 10 mm in the direction perpendicular to the 45° direction, to cut out a piece of rectangular film in a size of 120 mm×10 mm. This is used as a sample for measuring the piezoelectric constant.

The obtained sample is set on a tensile testing machine (TENSILON RTG-1250, produced by A&D Company Ltd.) in which a distance between chucks is set to 70 mm so as not to loosen. A force is applied cyclically at a crosshead speed of 5 mm/min such that an applied force reciprocated between 4N and 9N. On this occasion, for measuring an amount of electric charge generated on the sample corresponding to the applied force, a capacitor with the capacitance Qm (F) is connected in parallel to the sample, and an interterminal voltage Vm of the capacitor Cm (95 nF) is measured with a buffer amplifier. A generated electric charge amount Q (C) is calculated as a product of capacitance Cm and interterminal voltage Vm. Piezoelectric constant $d_{14}$ is calculated according to the following Formula.

$$d_{14} = (2\times t)/L\times Cm\cdot\Delta Vm/\Delta F$$

t: sample thickness (m)
L: distance between chucks (m)
Cm: capacitance of capacitor connected in parallel (F)
$\Delta Vm/\Delta F$: ratio of change in interterminal voltage of capacitor to change in force

A higher piezoelectric constant results in the larger displacement of the crystalline polymeric piezoelectric body responding to a voltage applied to the material, and reversely the higher voltage generated responding to a force applied to the crystalline polymeric piezoelectric body, and therefore is advantageous as the crystalline polymeric piezoelectric body.

Specifically, the piezoelectric constant $d_{14}$ measured by a stress-electric charge method method at 25°C is preferably 1 pC/N or higher, more preferably 3 pC/N or higher, and further preferably 4 pC/N or higher. Although there is no particular upper limit of the piezoelectric constant, it is preferably 50 pC/N or less, and more preferably 30 pC/N or less, for the crystalline polymeric piezoelectric body using the helical chiral polymer having optical activity (optically active polymer) from a viewpoint of the balance with transparency, *etc.* as described below.

Similarly, from a viewpoint of the balance with transparency, the piezoelectric constant $d_{14}$ measured by a resonance method is preferably 15 pC/N or less.

"MD direction" means herein a flow direction of a film (Machine Direction), and "TD direction" means a direction perpendicular to the MD direction and parallel to the principal plane of the film (Transverse Direction).

[Crystallinity]

The crystallinity of the crystalline polymeric piezoelectric body in the first aspect is preferably from 20% to 80%, and preferably from 30% to 70%.

In this regard, the crystallinity of the crystalline polymeric piezoelectric body refers to crystallinity determined by a DSC method.

When the crystallinity is within the range, the balance among the piezoelectricity, the transparency and the longitudinal tear strength of the crystalline polymeric piezoelectric body may be favorable, and whitening or breakage is less likely to occur in stretching the crystalline polymeric piezoelectric body, and therefore production is easy.

Specifically, when the crystallinity is 20% or more, decrease in the piezoelectricity is suppressed.

When the crystallinity is 80% or less, decrease in the longitudinal tear strength and the transparency is suppressed.

From a viewpoint of improving further the longitudinal tear strength and the transparency, the crystallinity is

more preferably 70% or less, further preferably 40.8% or less and especially preferably 40.0% or less.

In the first aspect the crystallinity of the crystalline polymeric piezoelectric body can be regulated within a range from 20% to 80% by regulating, for example, conditions for crystallization and stretching in producing the crystalline polymeric piezoelectric body.

The crystalline polymeric piezoelectric body in the first aspect especially preferably contains a helical chiral polymer having optical activity with a weight-average molecular weight of from 50,000 to 1,000,000, and has a crystallinity determined by a DSC method of from 20% to 80%.

[Transparency (internal haze)]

The transparency of the crystalline polymeric piezoelectric body can be evaluated, for example, by visual observation or haze measurement.

The internal haze of the crystalline polymeric piezoelectric body with respect to visible light is preferably 50% or less. In this regard, the internal haze is a value measured for the crystalline polymeric piezoelectric body with the thickness from 0.03 mm to 0.05 mm using a haze meter (TC-HIII DPK, produced by by Tokyo Denshoku Co., Ltd.) at 25°C according to JIS-K7105, and details of the measuring method are described in an Example below.

The internal haze of the crystalline polymeric piezoelectric body is preferably 40% or less, more preferably 20% or less, further preferably 13% or less, and still further preferably 5% or less. Further, from a viewpoint of improvement of longitudinal tear strength, the internal haze of the crystalline polymeric piezoelectric body is preferably 2.0% or less and especially preferably 1.0% or less.

Further, the lower the internal haze, the better the crystalline polymeric piezoelectric body is. However, from a viewpoint of the balance with the piezoelectric constant, *etc.* the internal haze is preferably from 0.0% to 40%, more preferably from 0.01% to 20%, further preferably from 0.01% to 13%, further preferably from 0.01% to 5%, still further preferably from 0.01 % to 2.0%, and especially preferably from 0.01 % to 1.0%.

Incidentally, the "internal haze" of the crystalline polymeric piezoelectric body means herein a haze from which a haze caused by the shape of an external surface of the crystalline polymeric piezoelectric body is excluded, as described in an Example below.

Especially preferably, the internal haze of the crystalline polymeric piezoelectric body in the first aspect with respect to visible light is 50% or less, and the piezoelectric constant $d_{14}$ measured at 25°C by a stress-electric charge method is 1 pC/N or more.

[Standardized molecular orientation MORc]

The standardized molecular orientation MORc of the crystalline polymeric piezoelectric body in the first aspect is preferably from 1.0 to 15.0, more preferably from 2.0 to 10.0, and further preferably from 4.0 to 10.0.

When the standardized molecular orientation MORc is 1.0 or more, a large number of molecular chains of the optically active polymer (for example, poly(lactic acid) molecular chains) are oriented in the stretching direction, and as the result a higher rate of generation of oriented crystals can be attained to exhibit higher piezoelectricity.

When the standardized molecular orientation MORc is 15.0 or less, the longitudinal tear strength can be further improved.

Further, from a viewpoint of improvement of adherence between the crystalline polymeric piezoelectric body and a surface layer, the standardized molecular orientation MORc is preferably 7.0 or less.

[Product of standardized molecular orientation MORc and crystallinity]

In the first aspect, the product of the crystallinity and the standardized molecular orientation MORc of the crystalline polymeric piezoelectric body is preferably from 25 to 700, more preferably from 40 to 700, and further preferably from 40 to 250. By regulation within the range, high piezoelectricity and high transparency can be maintained and deterioration of the longitudinal tear strength (namely, tear strength in a certain direction) can be suppressed.

When the product of the crystallinity and the standardized molecular orientation MORc of the crystalline polymeric piezoelectric body is 25 or more, decrease in the piezoelectricity is suppressed.

When the product of the crystallinity and the standardized molecular orientation MORc of the crystalline polymeric piezoelectric body is 700 or less, decrease in the longitudinal tear strength and the transparency is suppressed.

The product of the crystallinity and the MORc is more preferably from 50 to 200, and further preferably from 100 to 190.

In the first aspect the product of the crystallinity and the standardized molecular orientation MORc of the crystalline polymeric piezoelectric body can be regulated within the above range by regulating conditions for crystallization and stretching in producing the crystalline polymeric piezoelectric body.

[Dimensional stability]

It is preferable that the dimensional change rate of the crystalline polymeric piezoelectric body under heat is low, especially at a temperature of an environment where devices or apparatus described below, such as a loudspeaker and a touch panel, incorporating the piezoelectric body are used. Because, when the dimension of a piezoelectric material changes in a service environment of a device, positions of wiring, *etc.* connected with the crystalline polymeric piezoelectric body are moved, which may cause malfunctioning of the device. The dimensional stability of the crystalline polymeric piezoelectric body is evaluated by a dimensional change rate before and after a heat treatment for 10 min at 150°C, which is a temperature slightly higher than the service environment of a device as described below. The dimensional change rate is preferably 10% or less, and more preferably 5% or less.

<Production of crystalline polymeric piezoelectric body >

Examples of a production method of the crystalline polymeric piezoelectric body in the first aspect include a method, by which a sheet in an amorphous state including the optically active polymer is crystallized and stretched (in an optional order).

A sheet in an amorphous state means a sheet obtained by heating a lone optically active polymer or a mixture containing the optically active polymer to a temperature equal to or above the melting point Tm of the optically active polymer and then quenching the same. The quenching temperature is for example 50°C.

In a method for producing the crystalline polymeric piezoelectric body in the first aspect, the optically active polymer (poly(lactic acid)-type polymer, *etc.*) may be used singly, or a mixture of two or more optically active polymers (poly(lactic acid)-type polymers, *etc.*) described above, or a mixture of at least one optically active polymer described above and at least one other component may be used as a raw material for the crystalline polymeric piezoelectric body (or a sheet in an amorphous state).

The mixture is preferably a mixture obtained by melt-kneading.

Specifically, when two or more optically active polymers are mixed, or at least one optically active polymer and another component (for example, the inorganic filler and the crystal nucleating agent) are mixed, optically active polymer(s) to be mixed (according to need, together with another component) are melt-kneaded in a melt-kneading machine (LABO PLASTOMIXER, produced by Toyo Seiki Seisaku-sho, Ltd.) under conditions of the mixer rotating speed of from 30 rpm to 70 rpm at from 180°C to 250°C for from 5 min to 20 min to obtain a blend of plural kinds of optically active polymers, or a blend of the optically active polymer and another component such as an inorganic filler.

The crystalline polymeric piezoelectric body in the first aspect can be also produced by a production method including a step of stretching a sheet containing the optically active polymer (preferably a sheet in an amorphous state) mainly in a uniaxial direction and a step of an annealing treatment, in the order mentioned.

The crystalline polymeric piezoelectric body in the first aspect described above may also correspond to the crystalline polymeric piezoelectric body in the second aspect described below.

The crystalline polymeric piezoelectric body in the first aspect may be, for example, the crystalline polymeric piezoelectric body, the standardized molecular orientation MORc of which is from 2.0 to 10.0 as described above.

With respect to the crystalline polymeric piezoelectric body in the first aspect, the ratio of acrylic terminals of a polymer contained in the crystalline polymeric piezoelectric body may by regulated from viewpoints of enhancement of the adhesion between the crystalline polymeric piezoelectric body and the surface layer and enhancement of the moist heat resistance and tear strength of the crystalline polymeric piezoelectric body.

Specifically, with respect to the crystalline polymeric piezoelectric body in the first aspect, in a case in which a solution prepared by dissolving 20 mg of the crystalline polymeric piezoelectric body in 0.6 mL of deuterated chloroform is analyzed for a $^1$H-NMR spectrum, and then, based on the obtained $^1$H-NMR spectrum, the ratio of acrylic terminals of a polymer contained in the crystalline polymeric piezoelectric body is determined according to the following Formula (X), the ratio of acrylic terminals of the polymer is preferably from $2.0\times10^{-5}$ to $10.0\times10^{-5}$:

Ratio of acrylic terminals of the polymer = Integral value of peak derived from acrylic terminals of the polymer / Integral value of peak derived from methine groups in main chains of the polymer Formula (X).

The crystalline polymeric piezoelectric body in the first aspect may contain at least one kind of colorant for adjusting a hue. Examples of a colorant include a bluing agent for correcting a yellowish tint.

<Use of layered body>

A layered body according to the first aspect can be used in various fields including a loudspeaker, a headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, acoustic equipment, information processing equipment, measurement equipment, and a medical appliance.

A layered body according to the first aspect includes further an electrode unit, and can be used favorably as a piezoelectric device having the crystalline polymeric piezoelectric body, the surface layer, and the electrode unit in the order mentioned.

In this case, the crystalline polymeric piezoelectric body in the first aspect is preferably used as a piezoelectric element having at least two planes, and one of the two (the plane having at least a surface layer) and the other plane are provided with electrodes. It is enough if the electrodes are provided on at least 2 planes of the crystalline polymeric piezoelectric body. There is no particular restriction on the electrode, and examples thereof to be used include ITO, ZnO, IZO (registered trade mark), and an electroconductive polymer.

When an ITO electrode is formed on the crystalline polymeric piezoelectric body in the first aspect, an ITO with few defects can be formed by forming a hard coat layer as the surface layer on the piezoelectric body, and then forming an ITO electrode on the hard coat layer, so as to relax thermal deformation of the piezoelectric body during ITO crystallization by the hard coat layer. Further, by forming a refractive index adjusting layer between the hard coat layer and the ITO, mitigation of reflectance, prevention of pattern see-through, and mitigation of coloration become possible.

Further, the crystalline polymeric piezoelectric body in the first aspect and an electrode may be piled up one another, so as to have the surface layer intercalated between at least a part of the piezoelectric bodies and the electrodes, and used as a layered piezoelectric element. For example, units of an electrode and a crystalline polymeric piezoelectric body provided with surface layers on both the sides are piled up recurrently and finally a principal plane of a crystalline polymeric piezoelectric body not covered by an electrode is covered by an electrode. Specifically, that with 2 recurrent units is a layered piezoelectric element having an electrode, a surface layer, a crystalline polymeric piezoelectric body, a surface layer, an electrode, a surface layer, a crystalline polymeric piezoelectric body, a surface layer, and an electrode in the mentioned order. With respect to crystalline polymeric piezoelectric bodies to be used for the layered piezoelectric element, a layer of crystalline polymeric piezoelectric bodies and a layer of surface layers are required to be made of the layered body according to the first aspect, and other layers may not be made of a surface layer or a crystalline polymeric piezoelectric body of a layered body according to the first aspect.

In the case that surface layers and crystalline polymeric piezoelectric bodies of plural layered bodies according to the first aspect are included in the layered piezoelectric element, when an optically active polymer contained in a crystalline polymeric piezoelectric body in a layer has L-form optical activity, an optically active polymer contained in a crystalline polymeric piezoelectric body in another layer may be either of L-form and D-form. The location of the crystalline polymeric piezoelectric body may be adjusted appropriately according to an end use of the piezoelectric element.

Especially, if a principal plane of the crystalline polymeric piezoelectric body is provided with an electrode, it is preferable to provide a transparent electrode. In this regard, a transparent electrode means specifically that its internal haze is 40% or less (total luminous transmittance is 60% or more).

The piezoelectric element using the layered body according to the first aspect may be applied to the aforementioned various piezoelectric devices including a loudspeaker and a touch panel. A piezoelectric element provided with a transparent electrode is favorable for applications, such as a loudspeaker, a touch panel, and an actuator.

The layered body according to the first aspect described above may sometimes also correspond to the layered body according to the second aspect.

For example, with respect to the layered body according to the first aspect, the standardized molecular orientation MORc of the crystalline polymeric piezoelectric body, measured by a microwave transmission molecular orientation meter based on a reference thickness of 50 $\mu$m, may be from 2.0 to 10.0, and the surface layer may be placed so that at least a part thereof contacts the crystalline polymeric piezoelectric body, and comprises a carbonyl group and a polymeride.

<Second aspect>

A layered body according to the second aspect of the invention includes a crystalline polymeric piezoelectric body and a surface layer placed so that at least a part thereof contacts the crystalline polymeric piezoelectric body.

The standardized molecular orientation MORc of the crystalline polymeric piezoelectric body (hereinafter also referred to simply as "piezoelectric body"), measured by a microwave transmission molecular orientation meter based

on a reference thickness of 50 μm, is from 2.0 to 10.0. The surface layer contains a carbonyl group and a polymeride.

An adhesive surface layer for purpose of bonding with another member such as an electrode, or a protective surface layer for purpose of protection may be sometimes provided on the crystalline polymeric piezoelectric body. However, in a surface layer formed so as to contact at least a part of the crystalline polymeric piezoelectric body, peeling of the surface layer takes place occasionally, and therefore further improvement of adherence between the piezoelectric body and the surface layer has been desired.

Responding thereto, the second aspect is superior in adherence between the piezoelectric body and the surface layer owing to a constitution where the standardized molecular orientation MORc of the piezoelectric body is from 2.0 to 10.0 and the surface layer contains a carbonyl group as well as a polymeride.

Although the reason behind the above effect is not sufficiently clear, it is presumed as follows. When the standardized molecular orientation MORc of the piezoelectric body exceeds a certain value, electrical polarity is generated at a minute region on a surface of the piezoelectric body. The electrical polarity of the piezoelectric body is intensified, when the piezoelectric body contains a carbonyl group or an oxy group, which have high polarity. It is presumed therefore, when a surface layer contains a carbonyl group with high polarity as a functional group, an electrical interaction occurs between the piezoelectric body and a surface layer to improve adherence.

[Surface layer]

The surface layer in the second aspect means a layer existing on a surface of the piezoelectric body and at least a part of which contacting the piezoelectric body. Therefore, another member may be placed on the surface layer, and a surface layer may not necessarily be the outermost layer of a final formed article. Incidentally, examples of such other members to be placed on the surface layer of the layered body comprising the piezoelectric body and the surface layer include an electrode. The electrode may be an electrode which covers all the surface layer, or an electrode pattern constituted to cover only a part of the surface layer.

Further, a multilayer film layering plural functional layers may be formed on the piezoelectric body in the second aspect, and in this case the surface layer means a layer placed so that at least a part thereof contacts the piezoelectric body. Further, the surface layer in the second aspect may be present not only on a single side of the piezoelectric body but on both the sides, and the two may have different functions, or use different materials.

Kind (use) of surface layer

Examples of a surface layer to be formed on a surface of the piezoelectric body include various functional layers. Examples thereof include an easy adhesive layer, a hard coat layer, a refractive index adjusting layer, a hue adjustment layer, an anti-reflection layer, an anti-glare layer, an easily slidable layer, an anti-block layer, a protection layer, an adhesive layer, a sticking layer, an anti-static layer, a heat dissipation layer, an ultraviolet light absorption layer, an anti-Newton ring layer, a light scattering layer, a polarization layer, and a gas barrier layer.

On the layered body layering the piezoelectric body and the surface layer, another member may be placed on the surface layer, and examples of such another member include an electrode. In an exemplary embodiment where an electrode is provided, as the surface layer especially a functional layer, such as an easy adhesive layer, a hard coat layer, and a refractive index adjusting layer, is generally provided.

When a surface layer is formed, there is also an effect that a defect on the piezoelectric body surface, such as a die line or a bruise, is covered, so as to improve the appearance. In this case, when the refractive index difference between the piezoelectric body and a surface layer is smaller, reflection at an interface between the piezoelectric body and a surface layer is decreased and the appearance can be further improved.

By forming an sticking layer as a surface layer for the piezoelectric body by a wet coating method described below, not only a defect on a surface is covered but also a film roll, which does not require an OCA (Optical Clear Adhesive) or the like for lamination with another material at a downstream process step, can be produced. Further, when the thickness of an OCA or a sticking layer is large, mechanical energy applied from the outside, or mechanical energy generated in the piezoelectric body is relaxed in the OCA or the sticking layer to deteriorate the performance of a sensor or an actuator. However, since a sticking layer formed by a wet coating method can be easily made thinner than an OCA, it is advantageous.

The sticking layer may contain a three-dimensional cross-linked structure, which is however not mandatory, and may be formed only on a single side of the piezoelectric body, but also on both the sides.

Material

The surface layer contains a carbonyl group (-C(=O)-) and also a polymeride. When a surface layer contains a carbonyl group, the same is superior in adherence with the piezoelectric body exhibiting a standardized molecular

orientation MORc in the range.

Further, the polymeride in a surface layer has preferably a three-dimensional cross-linked structure. When the polymeride has a three-dimensional cross-linked structure, the adherence with the piezoelectric body can be further improved.

Examples of a method for forming a surface layer containing a carbonyl group and also a polymeride include a method of polymerizing a composition containing a compound having a carbonyl group and a functional compound having a reactive group. In this case the compound having a carbonyl group and the functional compound may be the same or different.

When the compound having a carbonyl group and the functional compound are the same, a reactive group itself of the functional compound may include a carbonyl group, or a structure other than the reactive group of the functional compound may include a carbonyl group. When the compound having a carbonyl group and the functional compound are different, the compound having a carbonyl group has 1 or more reactive groups which can react with the functional compound.

A polymerization reaction of the polymerization may be a reaction between reactive groups of a single kind, or reactive groups of different 2 or more kinds. When the polymerization reaction is a reaction between 2 or more kinds of different reactive groups, a compound including 2 or more kinds of reactive groups in the same compound may be used, or a mixture of a functional compound including 2 or more of the same reactive group and a functional compound including 2 or more other reactive groups, which are reactive with the former reactive group, may be used.

Examples of a reactive group for a reaction between reactive groups of a single kind (hereinafter also referred to simply as "homogeneous reactive group") include an acrylic group, a methacrylic group, a vinyl group, an allyl group, an isocyanate group, and an epoxy group. An acrylic group, a methacrylic group, and an isocyanate group have a carbonyl group in the reactive group. When a vinyl group, an allyl group, and an epoxy group are used, a compound having a carbonyl group in a structure other than the reactive group may be used.

From a viewpoint of formation of a three-dimensional cross-linked structure in the polymeride, when a bi- or more functional compound having such a homogeneous reactive group exists even partly in a composition, a three-dimensional cross-linked structure can be formed.

Examples of an applicable combination of reactive groups for the reaction of 2 or more kinds of reactive groups (hereinafter also referred to simply as "heterogeneous reactive group") include an epoxy group and a carboxy group, an epoxy group and an amino group, an epoxy group and a hydroxy group, an epoxy group and an acid anhydride group, an epoxy group and a hydrazide group, an epoxy group and a thiol group, an epoxy group and an imidazole group, an epoxy group and an isocyanate group, an isocyanate group and a carboxy group, an isocyanate group and an amino group, an isocyanate group and a hydroxy group, a carbodiimide group and an amino group, a carbodiimide group and a carboxy group, an oxazolino group and a carboxy group, and a hydrazide group and a carboxy group.

From a viewpoint of formation of a three-dimensional cross-linked structure in the polymeride, when a tri- or more functional compound having either or both of such heterogeneous reactive groups exists even partly in a composition, a three-dimensional cross-linked structure can be formed.

Among them, a carboxy group, an acid anhydride group, a hydrazide group, and an isocyanate group have a carbonyl group in the reactive groups. When a reactive group other than the above is used, a compound having a carbonyl group in a structure other than the reactive group may be used.

Examples of a functional compound having an epoxy group and a carbonyl group in the same molecule include an epoxy acrylate.

Examples of a functional compound having a hydroxy group and a carbonyl group in the same molecule include polyester polyol, polyurethane polyol, acrylic polyol, polycarbonate polyol, and partially carboxylated methylcellulose.

Examples of a functional compound having an amino group and a carbonyl group in the same molecule an amine-terminal polyamide, an amine-terminal polyimide, and an amine-terminal polyurethane.

In the second aspect, among the above, a polymeride of a compound having a (meth)acrylic group is more preferable.

In this regard, a "(meth)acrylic group" represents as described above at least one of an acrylic group or a methacrylic group.

Formation method

As a method for forming a surface layer, a heretofore widely used publicly known method can be used appropriately, and there is for example a wet coating method. For example, a surface layer is formed by coating a coating liquid dispersing or dissolving a material for forming a surface layer (a polymerizable compound or a polymeride of a polymerizable compound), and followed, if necessary, by a treatment such as drying. The polymerizable compound may be polymerized before coating or after coating.

If necessary, the-material (a polymerizable compound) may be heated or irradiated with an active energy ray

(ultraviolet light, electron beam, radiation, *etc.)* during the polymerization to cure a surface layer. By decreasing the equivalent of a reactive group in a material (polymerizable compound) for forming a surface layer (namely, by increasing the number of reactive groups contained in the polymerizable compound per unit molecular weight), the crosslink density can be enhanced and the adherence with the piezoelectric body can be further improved.

Among the polymerides, an active energy ray curable resin cured by irradiation with an active energy ray (ultraviolet light, electron beam, radiation, *etc.*) is preferable. By inclusion of an active energy ray curable resin, the production efficiency is improved, and the adherence with the piezoelectric body can be further improved.

Among active energy ray curable resins, an ultraviolet curable resin cured by irradiation with ultraviolet light is especially preferable.

Three-dimensional cross-linked structure

A surface layer contains preferably a polymeride containing a carbonyl group and having a three-dimensional cross-linked structure. By inclusion of a three-dimensional cross-linked structure the adherence with the piezoelectric body can be further improved.

As a means for producing a polymeride having a three-dimensional cross-linked structure, there is, for example, a method of polymerizing a composition containing a functional compound having 2 or more reactive groups. There is also a method of using a cross-linking agent, such as an isocyanate, a polyol, and an organic peroxide. A combination of a plurality of the above means may be also used.

Examples of a bi- or more functional compound include a (meth)acrylic compound having 2 or more (meth)acrylic groups in a molecule.

In this regard, "having 2 or more (meth)acrylic groups in a molecule" means that a compound has at least one of an acrylic group or a methacrylic group in a molecule and the total number of acrylic groups and methacrylic groups in a molecule is 2 or higher.

Example of a tri- or more functional compound include an epoxy compound having 3 or more epoxy groups in a molecule, and an isocyanate compound having 3 or more isocyanate groups in a molecule.

In this regard, as a method for confirming whether a material contained in a surface layer is a polymeride having a three-dimensional cross-linked structure or not, there is for example a method to measure a gel fraction.

Specifically, a gel fraction can be derived from an insoluble obtained after dipping a surface layer in a solvent for 24 hours. In either case, in which a solvent is a hydrophilic solvent such as water, or a lipophilic solvent such as toluene, if a gel fraction is beyond a certain level, it may be presumed that the material has a three-dimensional cross-linked structure.

In the case of a wet coating method, a coating liquid may be coated on to a web of the piezoelectric body before stretching and thereafter the piezoelectric body is stretched, followed by curing, or a coating liquid may be coated on to an already stretched web of the piezoelectric body, and cured.

Further, according to a purpose, various organic substances, and inorganic substances, such as a refractive index adjuster, an UV absorber, a leveling agent, an antistatic agent, and an anti-blocking agent, may be added to a surface layer.

Surface treatment

A surface of the piezoelectric body may be treated by a corona treatment or an Itro treatment, an ozone treatment, a plasma treatment, or the like from viewpoints of additional improvement of adherence between the piezoelectric body surface and a surface layer, or a coating property of a surface layer on to a surface of the piezoelectric body.

Thickness d

Although there is no particular restriction on the thickness (average thickness) d of a surface layer, a range of from 0.01 μm to 10 μm is preferable.

When the thickness d is not below the lower limit, a surface layer exhibits, for example, a function as a hard coat layer.

Meanwhile, when the thickness d is not above the upper limit, in a case in which an electrode is provided further on the surface layer of the layered body, a larger electric charge is generated at the electrode.

The upper limit of the thickness d is more preferably 6 μm or less, and further preferably 3 μm or less. The lower limit is more preferably 0.2 μm or more, and further preferably 0.3 μm or more.

Incidentally, surface layers may be present on both sides of the piezoelectric body, and in this case the thickness d represents the total thickness of the two.

The thickness d of a surface layer in the second aspect is determined by the same method as for the thickness

of a surface layer in the first aspect.

Relative dielectric constant

The relative dielectric constant of a surface layer is preferably 1.5 or more, more preferably from 2.0 to 20,000, and further preferably from 2.5 to 10,000.
When the relative dielectric constant is in the range, in a case in which an electrode is provided further on the surface layer of the layered body, a larger electric charge is generated at the electrode.
The relative dielectric constant of the surface layer in the second aspect is determined by the same method as for the relative dielectric constant in the first aspect.

Internal haze of surface layer

The internal haze of a surface layer is preferably 10% or less, more preferably from 0.0% to 5%, and further preferably from 0.01% to 2%.
When the internal haze is in the range, the surface layer exhibits superior transparency, and is effectively applicable, for example, to a touch panel.
The internal haze of the surface layer in the second aspect is determined by the same method as for the internal haze of the surface layer in the first aspect.
Further, the internal haze of the layered body according to the second aspect is determined by the same method as for the internal haze of the layered body according to the first aspect.

[crystalline polymeric piezoelectric body]

Polymers are oriented in the crystalline polymeric piezoelectric body in the second aspect.
As an indicator of the orientation a "molecular orientation ratio MOR" described above is used.
A molecular orientation ratio MOR in the second aspect has the same meaning as a molecular orientation ratio MOR in the first aspect, and is determined by the same method as for the molecular orientation ratio MOR in the first aspect.

[Standardized molecular orientation MORc]

Standardized molecular orientation MORc in the second aspect means a MOR value to be measured at the reference thickness tc of 50 μm, and can be determined by the same method as the method for a standardized molecular orientation MORc in the first aspect.
The standardized molecular orientation MORc of the piezoelectric body in the second aspect is from 2.0 to 10.0.
When the standardized molecular orientation MORc is less than 2.0, high adherence with a surface layer cannot be attained. Further, the number of polymer molecular chains (for example, poly(lactic acid) molecular chains) aligned in the stretching direction decreases, and consequently the generation rate of oriented crystals becomes low and high piezoelectricity is not developed.
Meanwhile, when the standardized molecular orientation MORc exceeds 10.0, high adherence with a surface layer cannot be attained either. Also longitudinal tear strength (namely tear strength in a specific direction; the same shall apply hereinbelow) tends to decrease.
From a viewpoint of improvement of adherence between the crystalline polymeric piezoelectric body and the surface layer, the standardized molecular orientation MORc is preferably 8.0 or less, and more preferably 7.0 or less.
The standardized molecular orientation MORc is further preferably from 2.5 to 8.0, still further preferably from 2.5 to 7.0, and still further preferably from 3.0 to 4.5.
The standardized molecular orientation MORc can be regulated by crystallization conditions (heating temperature and heating time), and stretching conditions (stretching temperature and stretching speed) during production of the crystalline polymeric piezoelectric body.
Meanwhile, it can be converted to a relationship between standardized molecular orientation MORc of the piezoelectric body and birefringence $\Delta n$, which equals to retardation divided by the film thickness of the piezoelectric body.
More specifically, the retardation can be measured by an RETS 100, produced by Otsuka Electronics Co., Ltd. Further, MORc and $\Delta n$ are approximately in a linearly proportional relationship, and if $\Delta n$ is 0, MORc is 1.

[Ratio of acrylic terminals of polymer]

In the second aspect, the ratio of acrylic terminals of a polymer contained in the crystalline polymeric piezoelectric body is preferably regulated from the viewpoints of enhancement of adhesion between the crystalline polymeric piezoelectric body and the surface layer and enhancement of moist heat resistance and tear strength of the crystalline polymeric piezoelectric body.

More specifically, in a case in which a solution prepared by dissolving 20 mg of the crystalline polymeric piezoelectric body in 0.6 mL of deuterated chloroform is analyzed for a $^1$H-NMR spectrum, and then, based on the obtained $^1$H-NMR spectrum, the ratio of acrylic terminals of a polymer contained in the crystalline polymeric piezoelectric body is determined according to the following Formula (X), the ratio of acrylic terminals of the polymer is preferably from $2.0\times10^{-5}$ to $10.0\times10^{-5}$.

Ratio of acrylic terminals of the polymer = Integral value of peak derived from acrylic terminals of the polymer / Integral value of peak derived from methine groups in main chains of the polymer Formula (X)

In this regard, acrylic terminals may be reworded as acryloyl groups.

Furthermore, an integral value of peak derived from acrylic terminals of the polymer means an average value of the integral values of peaks derived respectively from 3 protons of each acrylic terminal (each acryloyl group).

In a case in which a polymer contained in the crystalline polymeric piezoelectric body is a polymer having a main chain including a repeating unit represented by the Formula (1) described below, an acrylic terminal is conceivably formed by breakage of a bond between an oxygen atom (O) in an ether bond (-O-) and a carbon atom (C) in an methine group (CH) in a repeating unit represented by the Formula (1) described below caused by irradiation with an active energy ray (for example, ultraviolet light), heat (for example, a melt-knead process in producing the crystalline polymeric piezoelectric body), *etc.*, (namely, by decrease in the molecular weight of the polymer due to degradation). Further, it is believed that a carboxy group (COOH) is formed concurrently with the acrylic terminal.

When the ratio of acrylic terminals of the polymer is $2.0\times10^{-5}$ or more, adherence between the crystalline polymeric piezoelectric body and the surface layer is further improved. Although the reason behind the above is not sufficiently clear, the inventors presume as follows. When the ratio is $2.0\times10^{-5}$ or more, acrylic terminals of the polymer and reactive groups of the surface layer react to form a sufficient number of chemical bonds, which contribute effectively to improvement of the adherence.

On the other hand, when the ratio of acrylic terminals (acryloyl groups) of the polymer is $10.0\times10^{-5}$ or less, moist heat resistance and tear strength of the crystalline polymeric piezoelectric body are further improved. The reason behind the above is presumably because the ratio of $10.0\times10^{-5}$ or less means a certain degree of suppression of polymer degradation to be caused by irradiation with an active energy ray (for example, ultraviolet light), heat (for example, a melt-knead process in producing the crystalline polymeric piezoelectric body), *etc.* In other words, an amount of a carboxy group (COOH), which exerts a negative influence on moist heat resistance, is small, so that decrease in a molecular weight exerting negative influence on tear strength is suppressed, and the moist heat resistance and tear strength are presumably improved further.

The ratio of acrylic terminals of a polymer is more preferably $3.0\times10^{-5}$ or more, further preferably $4.0\times10^{-5}$ or more, still further preferably $5.0\times10^{-5}$ or more, and especially preferably $6.0\times10^{-5}$ or more.

Also the ratio of acrylic terminals of a polymer is more preferably $9.0\times10^{-5}$ or less, and further preferably $8.0\times10^{-5}$ or less.

An example of the Formula (X) is an example in which the integral value of peak derived from acrylic terminals of the polymer is an average value ($I_{5.9\text{-}6.4}$) of integral values of peaks included in the region of $\delta$ 5.9-6.4 ppm, the integral value of peak derived from methine groups in main chains of the polymer is an integral value ($I_{5.1}$) of a peak at a position of $\delta$ 5.1 ppm, and the ratio of acrylic terminals of the polymer is a ratio [$I_{5.9\text{-}6.4}/I_{5.1}$].

In the example, in the region of $\delta$ 5.9-6.4 ppm, peaks derived from 3 protons in each acrylic terminal (each acryloyl group) respectively appear. The average value ($I_{5.9\text{-}6.4}$) of integral values is an average value of integral values of the respective peaks that appear.

The $^1$H-NMR spectrum is measured by a proton single pulse method under the following conditions.

- Measurement conditions for $^1$H-NMR spectrum -

Measuring apparatus: ECA-500 produced by JEOL Ltd., or an equivalent apparatus (proton-nuclear resonance frequency 500 MHz or more)
Solvent: deuterated chloroform (chloroform-d)
Measurement temperature: room temperature

Pulse angle: 45°
Pulse interval: 6.53 sec
Cumulative number: 512 times or more

Material

Although there is no particular restriction on an material of the piezoelectric body in the second aspect, for example, a polymer having a repeating unit structure including a functional group of at least one of a carbonyl group (-C(=O)-) or an oxy group (-O-) is contained preferably.

By containing a polymer having a repeating unit structure including a functional group of at least one of a carbonyl group or an oxy group, the adherence with a surface layer can be further improved effectively due to interaction with a carbonyl group (-C(=O)-) contained in the surface layer.

In the second aspect, especially, a helical chiral polymer having optical activity is favorably used as the polymer.

A helical chiral polymer having optical activity (hereinafter also referred to as "optically active polymer") in the second aspect has the same meaning as a helical chiral polymer having optical activity in the first aspect, and the preferable ranges (for example, preferable ranges of kind and weight-average molecular weight) are also identical. For example, a preferable range of weight-average molecular weight of the optically active polymer is from 50,000 to 1,000,000. Further, a preferable range of the optical purity of the optically active polymer is 95.00%ee or higher.

In the second aspect, among the above optically active polymers, a polymer with the main chain including a repeating unit represented by the following Formula (1) is preferable from a viewpoint of enhancement of the optical purity and improvement of the piezoelectricity.

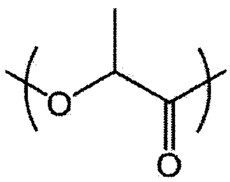

(1)

As an example of a polymer with the main chain including a repeating unit represented by the Formula (1) is named a poly(lactic acid)-type polymer. Among others poly(lactic acid) is preferable, and a homopolymer of L-lactic acid (PLLA) or a homopolymer of D-lactic acid (PDLA) is most preferable.

A poly(lactic acid)-type polymer to be used in the second aspect has the same meaning as a poly(lactic acid)-type polymer to be used in the first aspect, and the preferable ranges are also identical.

A preferable range of the content of the optically active polymer in the crystalline polymeric piezoelectric body in the second aspect is similar to the preferable range of the content of the optically active polymer in the crystalline polymeric piezoelectric body in the first aspect (namely, 80 mass % or more with reference to the total mass of the crystalline polymeric piezoelectric body).

The crystalline polymeric piezoelectric body in the second aspect may also contain components other than the aforedescribed optically active polymers.

Other components to be contained in the crystalline polymeric piezoelectric body in the second aspect are similar to other components to be contained in the crystalline polymeric piezoelectric body in the first aspect, and the preferable ranges (for example, preferable ranges of kind and content in the crystalline polymeric piezoelectric body) are also identical.

Further, from a viewpoint of better inhibition of a structural change by hydrolysis, *etc.*, the crystalline polymeric piezoelectric body in the second aspect preferably contain a stabilizer such as a carbodiimide compound as represented by CARBODILITE (registered trade mark).

The crystalline polymeric piezoelectric body in the second aspect preferably does not contain a component other than a helical chiral polymer having optical activity from a viewpoint of transparency.

- Stabilizer -

The crystalline polymeric piezoelectric body in the second aspect may contain a stabilizer.

A stabilizer applicable to the second aspect is the same as a stabilizer applicable to the first aspect, and the preferable ranges (for example, preferable ranges of kind and addition amount, or a preferable mode of combining 2 or more stabilizers) are also identical.

The crystalline polymeric piezoelectric body in the second aspect may contain at least one kind of colorant for adjusting a hue.

As the colorant a bluing agent is used for correcting a yellowish tint.

Adjustment of a hue is conducted for purpose of correction of the hue of the crystalline polymeric piezoelectric body itself, or correction of the hue of another layer, when various layered bodies are formed in assembling the crystalline polymeric piezoelectric body to a device. Examples of the layered body include a layered body of the crystalline polymeric piezoelectric body and a transparent electroconductive film provided with an ITO electrode. In this case, since an ITO electrode has a yellowish tint, the hue as a layered body can be corrected by adding a bluing agent to the crystalline polymeric piezoelectric body. Further, when the crystalline polymeric piezoelectric body has the surface layer such as a hard coat layer, the hue of the crystalline polymeric piezoelectric body or a layered body including the polymeric piezoelectric body can be adjusted by adding a colorant to the surface layer.

The addition amount of the colorant is regulated considering the thickness of the crystalline polymeric piezoelectric body or the surface layer, to which the colorant is added, the absorbance at the wavelength of light which added the colorant utilizes, and the intensity of a hue to be adjusted.

With respect to a bluing agent, description in Paragraphs 0172 to 0190 of JP-A No. 2013-227547 may be referred to appropriately.

When the crystalline polymeric piezoelectric body contains the bluing agent, the content of the bluing agent is preferably from $0.1\times10^{-4}$ to $100.0\times10^{-4}$ part by mass with respect to 100 parts by mass of the crystalline polymeric piezoelectric body, and more preferably from $0.3\times10^{-4}$ to $70.0\times10^{-4}$ part by mass.

When the crystalline polymeric piezoelectric body contains the bluing agent, there is no particular restriction on a timing or a method of addition of the bluing agent.

Examples of a method of addition include a method by which the bluing agent is directly mixed or kneaded to a predetermined concentration in a polymer (for example, the helical chiral polymer), and a method by which a masterbatch prepared in advance by mixing the bluing agent at a high concentration is blended with a polymer (for example, the helical chiral polymer) to a predetermined concentration.

As the bluing agent, a colorant (pigment or dye) exhibiting a blue or violet color by absorbing orange to yellow light may be used, and among others a colorant (preferably a dye) with the maximum absorption wave length of from 520 nm to 600 nm (preferably from 540 nm to 580 nm) is more preferable.

Examples of a dye with the maximum absorption wave length of from 520 nm to 600 nm include, a monoazo dye represented by Generic Name: Solvent Violet 21, a triarylmethane dye represented by Generic Name: Solvent Blue 2 [CA No. (Color Index No.) 42563], a phthalocyanine dye represented by Generic Name: Solvent Blue 25 [CA No. 74350], an anthraquinone dye represented by Generic Name: Solvent Violet 13 [CA No. 60725], Generic Name: Solvent Violet 36, and Generic Name: Solvent Blue 97; cobalt blue, alkali blue, Victoria blue lake, phthalocyanine blue, metal-free phthalocyanine blue, partially chlorinated phthalocyanine blue, Fast Sky blue, and indanthrene blue BC. Among them, an anthraquinone dye is preferable because of easy availability.

Any anthraquinone dye may be used, insofar as it has an anthraquinone structure in its molecular structure, and is usable for coloring a thermoplastic resin.

Among others, a compound represented by the following Formula (2) is favorably used, because it can enhance the lightness of the crystalline polymeric piezoelectric body.

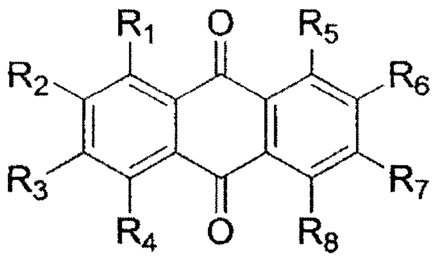

(2)

In the Formula (2) $R_1$ to $R_8$ represent independently a hydrogen atom, a halogen atom, a hydroxy group, an alkyl group having 1 to 3 carbon atoms, or an amino group which may have a substituent.

Examples of a substituent which an amino group in the Formula (2) may have include an alkyl group and an aryl group. Examples of an alkyl group which an amino group may have as a substituent include an alkyl group having 1 to 6 carbon atoms, and examples of an aryl group which an amino group may have as a substituent include an aryl group with 3 or less ring structures.

Examples of an aryl group with 3 or less ring structures include a phenyl group, a naphthyl group, an anthryl group, and a phenanthryl group, and such an aryl group may be substituted with an alkyl group having 3 or less carbon atoms. As an aryl group which an amino group may have as a substituent, a phenyl group which may be substituted with an alkyl group is more preferable, a phenyl group which may be substituted with an alkyl group having 3 or less

carbon atoms is more preferable, and a phenyl group having at least one methyl group is especially preferable.

Specific examples of an anthraquinone dye include Generic Name: Solvent Violet 13 [CA No. (Color Index No.) 60725, trade name "MACROLEX VIOLET B" produced by LANXESS, "DIARESIN BLUE G" produced by Mitsubishi Chemical Corporation, "SUMIPLAST VIOLET B" produced by Sumitomo Chemical Co., Ltd.]; Solvent Violet 14; Generic Name: Solvent Violet 31 [CA No. 68210), trade name "DIARESIN VIOLET D" produced by Mitsubishi Chemical Corporation]; Solvent Violet 33 [CA No.60725, trade name "DIARESIN BLUE J" produced by Mitsubishi Chemical Corporation]; Solvent Violet 36 [CA No. 68210, trade name "MACROLEX VIOLET 3R" produced by LANXESS]; Solvent Blue 45 [CANo. 61110, trade name "TETRAZOLE BLUE RLS" produced by Sandoz]; Generic Name: Solvent Blue 94 [CANo. 61500, trade name "DIARESIN BLUE N" produced by Mitsubishi Chemical Corporation]; Generic Name: Solvent Blue 97, ["MACROLEX BLUE RR" produced by LANXESS]; Generic Name: Solvent Blue 45; Generic Name: Solvent Blue 87; and Generic Name: Disperse Violet 28, KAYASET BLUE FR produced by Nippon Kayaku Co., Ltd.; KAYASET BLUE N [produced by Nippon Kayaku Co., Ltd.]; KAYASET BLUE 814 [produced by Nippon Kayaku Co., Ltd.]; and FS BLUE 1504 [produced by Arimoto Chemical Co., Ltd.].

Among them preferable are Generic Name: Solvent Violet 13 ("MACROLEX VIOLET B" produced by LANXESS); Generic Name: Solvent Violet 36 ("MACROLEX VIOLET 3R" produced by LANXESS); Generic Name: Solvent Blue 97 ("MACROLEX BLUE RR" produced by LANXESS); KAYASET BLUE FR (produced by Nippon Kayaku Co., Ltd.); KAYASET BLUE N (produced by Nippon Kayaku Co., Ltd.); KAYASET BLUE 814 (produced by Nippon Kayaku Co., Ltd.), and FS BLUE 1504 (produced by Arimoto Chemical Co., Ltd.).

As a bluing agent, a pigment with a maximum absorption wave length of from 520 to 600 nm (more preferably from 540 to 580 nm) may be used, or a combination of a dye with a maximum absorption wave length of from 520 to 600 nm (more preferably 540 to 580 nm) and a pigment with a maximum absorption wave length of from 520 to 600 nm (more preferably from 540 to 580 nm) may be used.

<Physical properties of crystalline polymeric piezoelectric body >

The crystalline polymeric piezoelectric body in the second aspect has preferably a high piezoelectric constant (a piezoelectric constant $d_{14}$ measured by a stress-electric charge method at 25°C is preferably 1 pC/N or higher). Further, the crystalline polymeric piezoelectric body in the second aspect is preferably superior in transparency, and longitudinal tear strength (tear strength in a specific direction).

A piezoelectric constant $d_{14}$ by a stress-electric charge method in the second aspect has the same meaning as a piezoelectric constant $d_{14}$ by a stress-electric charge method in the first aspect, and the preferable range (for example, preferably 1 pC/N or more) is also identical.

The crystallinity of the crystalline polymeric piezoelectric body in the second aspect has the same meaning as the crystallinity of the crystalline polymeric piezoelectric body in the first aspect, and the preferable range (namely, preferably from 20% to 80%, more preferably from 30% to 70%, *etc.)* is also identical.

In the second aspect the crystallinity of the crystalline polymeric piezoelectric body can be regulated within a range from 20% to 80% by regulating, for example, conditions for crystallization and stretching in producing the crystalline polymeric piezoelectric body.

The crystalline polymeric piezoelectric body in the second aspect especially preferably contains a helical chiral polymer having optical activity with a weight-average molecular weight of from 50,000 to 1,000,000, and has a crystallinity determined by a DSC method of from 20% to 80%.

The internal haze with respect to visible light in the second aspect has the same meaning as the the internal haze with respect to visible light in the first aspect, and the preferable range (namely, preferably 50% or less, more preferably 40% or less, further preferably 20% or less, and still further preferably 13% or less, *etc.)* is also identical.

Especially preferably, the internal haze of the crystalline polymeric piezoelectric body in the second aspect with respect to visible light is 50% or less, and the piezoelectric constant $d_{14}$ measured at 25°C by a stress-electric charge method is 1 pC/N or more.

A preferable range of the product of the crystallinity and the standardized molecular orientation MORc of the crystalline polymeric piezoelectric body in the second aspect is the same as a preferable range of the product of the crystallinity and the standardized molecular orientation MORc of the crystalline polymeric piezoelectric body in the first aspect (namely, preferably from 25 to 700, more preferably from 40 to 700, and further preferably from 40 to 250, *etc.).*

In the second aspect the product of the crystallinity and the standardized molecular orientation MORc of the crystalline polymeric piezoelectric body can be regulated within a preferable range by regulating conditions for crystallization and stretching in producing the crystalline polymeric piezoelectric body.

A preferable range of the dimensional stability (the rate of dimensional change before and after a treatment at 150°C for 10 min) of the crystalline polymeric piezoelectric body in the second aspect is the same as a preferable range of the dimensional stability (the rate of dimensional change before and after a treatment at 150°C for 10 min) of the crystalline polymeric piezoelectric body in the first aspect.

<Production of crystalline polymeric piezoelectric body >

Examples of a production method of the crystalline polymeric piezoelectric body in the second aspect include the same method as a production method of the crystalline polymeric piezoelectric body in the first aspect, and the preferable range is also identical.

<Use of layered body>

A use of a layered body according to the second aspect is the same as a use of a layered body according to the first aspect, and the preferable range is also the same.

EXAMPLES

The first aspect and the second aspect will be described below more specifically by way of Examples, provided that the first aspect and the second aspect are not limited to the following Examples.

<Examples of the first aspect>

Examples of the first aspect (Examples 1A to 7A) and Comparative Examples (Comparative Examples 1A and 2A) will be described.

[Example 1A]

<Production of piezoelectric body>

To 100 parts by mass of poly(lactic acid) (Registered trademark LACEA, H-400 produced by Mitsui Chemicals, Inc.; weight-average molecular weight Mw: 200,000), 1.0 part by mass of a stabilizer (Trade name STABAXOL I produced by Rhein Chemie Rheingau GmbH; bis-2,6-diisopropylphenyl carbodiimide) was added and blended in a dry state to prepare a source material. The prepared source material was charged into a hopper of an extruder, which was then extruded with heating at from 220°C to 230°C through a T-die, and brought into contact with a cast roll at 50°C for 0.3 min to form a 150 μm-thick pre-crystallized sheet (pre-crystallization step). The crystallinity of the pre-crystallized sheet was measured to find 6%.

Stretching of the produced pre-crystallized sheet was started at a stretching speed of 3 m/min by roll-to-roll with heating at 70°C and continued up to 3.5-fold uniaxially in the MD direction (stretching step). The thickness of the obtained film was 47.2 μm.

Then the uniaxially stretched film was contacted with a roll heated to 145°C for 15 sec by roll-to-roll to perform an annealing treatment, and thereafter quenched to produce a crystalline polymeric piezoelectric body (hereinafter referred to as "piezoelectric body") (annealing treatment step).

- Measurement of amounts of L-form and D-form of optically active polymer (poly(lactic acid)) -

Into a 50 mL Erlenmeyer flask 1.0 g of a weighed-out sample (piezoelectric body) was charged, to which 2.5mL of IPA (isopropyl alcohol) and 5 mL of a 5.0 mol/L sodium hydroxide solution were added. The Erlenmeyer flask containing the sample solution was then placed in a water bath at the temperature of 40°C, and stirred until poly(lactic acid) was completely hydrolyzed for about 5 hours.

After the sample solution was cooled down to room temperature, 20 mL of a 1.0 mol/L hydrochloric acid solution was added for neutralization, and the Erlenmeyer flask was stoppered tightly and stirred well. The sample solution (1.0 mL) was dispensed into a 25 mL measuring flask and diluted to 25mL with a mobile phase to prepare a HPLC sample solution 1. Into an HPLC apparatus 5 μL of the HPLC sample solution 1 was injected, and D/L-form peak areas of poly(lactic acid) were determined under the following HPLC conditions. The amounts of L-form and D-form were calculated therefrom. From the results, the optical purity (%ee) was calculated. The results are shown in the following Table 1.

In the following Table 1, "LA" stands for poly(lactic acid).

HPLC measurement conditions:
Column: Optical resolution column, SUMICHIRAL OA5000 (produced by Sumika Chemical Analysis Service, Ltd.)
Measuring apparatus: Liquid chromatography (produced by Jasco Corporation)
Column temperature: 25°C

Mobile phase: 1.0 mM-copper(II) sulfate buffer solution/IPA = 98/2 (VN)
Copper(II) sulfate/IPA/water = 156.4 mg/20 mL/980 mL
Mobile phase flow rate: 1.0 mL/min
Detector: Ultraviolet detector (UV 254 nm)

<Weight-average molecular weight and molecular weight distribution>

The weight-average molecular weight (Mw) and the molecular weight distribution (Mw/Mn) of a polymer (optically active polymer) contained in the piezoelectric body was measured using a gel permeation chromatograph (GPC) by the following GPC measuring method. The results are shown in the following Table 1.

- GPC measuring method -

Measuring apparatus: GPC-100 (produced by Waters Corporation)
Column: Shodex LF-804 (produced by Showa Denko K.K.)
Preparation of sample: The piezoelectric body was dissolved in a solvent (chloroform) at 40°C to prepare a sample solution with the concentration of 1 mg/mL.
Measuring conditions: 0.1 mL of the sample solution was introduced into the column at a temperature of 40°C and a flow rate of 1 mL/min by using chloroform as a solvent, and the concentration of the sample in the sample solution separated by the column was measured by a differential refractometer. The weight-average molecular weight (Mw) of a polymer was calculated based on a universal calibration curve prepared using polystyrene standard samples.

<Measurement of physical properties and evaluation>

With respect to the piezoelectric body, the melting point Tm, crystallinity, thickness, internal haze, piezoelectric constant, standardized molecular orientation MORc, in-plane retardation, and birefringence were measured as follows.
The results are shown in Table 1.

- Melting point Tm, and crystallinity -

10 mg of the piezoelectric body was weighed accurately and measured by a differential scanning calorimeter (DSC-1, produced by by Perkin Elmer Inc.) at a temperature increase rate of 10°C/min to obtain a melting endothermic curve. From the obtained melting endothermic curve the melting point Tm, and crystallinity were obtained.

- Internal haze of piezoelectric body -

The internal haze of the piezoelectric body (hereinafter also referred to as "internal haze (H1)") was obtained by the following method.
Firstly, the haze (H2) was measured by placing in advance only a silicone oil (Shin-Etsu Silicone (trade mark), grade: KF96-100CS; produced by Shin-Etsu Chemical Co., Ltd.) between 2 glass plates; then the haze (H3) was measured by placing the piezoelectric body, whose surfaces were wetted uniformly with the silicone oil, between the 2 glass plates; and finally the internal haze (H1) of the piezoelectric body was obtained by calculating the difference between the above two according to the following formula:

$$\text{Internal haze (H1)} = \text{haze (H3)} - \text{haze (H2)}$$

The haze (H2) and haze (H3) were determined respectively by measuring the light transmittance in the thickness direction using the following apparatus under the following measuring conditions.

Measuring apparatus: HAZE METER TC-HIIIDPK (produced by Tokyo Denshoku Co., Ltd.)
Sample size: Width 30 mm×length 30 mm
Measuring conditions: According to JIS-K7105
Measuring temperature: Room temperature (25°C)

[Piezoelectric constant (stress-electric charge method)]

The piezoelectric body was cut into a length of 150 mm in a direction 45° to the stretching direction (MD direction) of the piezoelectric body and into a length of 50 mm in the direction perpendicular to the 45° direction, to prepare a rectangular specimen.

Next, the specimen was set on a stage of a SIP-600 from Showa Shinku Co., Ltd. and A1 was deposited on a side of the specimen to a deposited A1 thickness of approx. 50 nm. Then A1 was deposited similarly on the other side of the specimen. Thus, A1 electroconductive layers were formed on both the sides of the specimen.

The specimen (crystalline polymeric piezoelectric body) of 150 mm×50 mm with the A1 electroconductive layers on both sides was cut into a length of 120 mm in a direction 45° to the stretching direction (MD direction) of the piezoelectric body and into 10 mm in the direction perpendicular to the 45° direction, to cut out a piece of rectangular film in a size of 120 mm×10 mm. This was used as a sample for measuring the piezoelectric constant.

The obtained sample was set on a tensile testing machine (TENSILON RTG-1250, produced by A&D Company Ltd.) in which a distance between chucks was set to 70 mm so as not to loosen. A force was applied cyclically at a crosshead speed of 5 mm/min such that an applied force reciprocated between 4N and 9N. On this occasion, for measuring an amount of electric charge generated on the sample corresponding to the applied force, a capacitor with the capacitance Qm (F) was connected in parallel to the sample, and an interterminal voltage Vm of the capacitor Cm (95 nF) was measured with a buffer amplifier. A generated electric charge amount Q (C) was calculated as a product of capacitance Cm and interterminal voltage Vm. Piezoelectric constant $d_{14}$ was calculated according to the following Formula.

$$d_{14} = (2\times t)/L\times Cm\cdot\Delta Vm/\Delta F$$

t: sample thickness (m)
L: distance between chucks (m)
Cm: capacitance of capacitor connected in parallel (F)
$\Delta$Vm/$\Delta$F: ratio of change in interterminal voltage of capacitor to change in force

- Standardized molecular orientation MORc -

Standardized molecular orientation MORc was measured by a microwave molecular orientation meter MOA-6000 produced by Oji Scientific Instruments Co., Ltd. The reference thickness tc was set at 50 $\mu$m.

- In-plane retardation and birefringence -

In-plane retardation (phase difference with respect to in-plane direction) Re was measured under the following conditions:

- Measurement wavelength: 550 nm
- Measuring apparatus: Retardation film/optical material inspection apparatus RETS-100 produced by Otsuka Electronics Co., Ltd.

Further, birefringence is expressed as a quotient of the value of the in-plane retardation divided by the thickness of the piezoelectric body.

[Table 1]

| Piezoelectric body | Polymer | Chirality | Mw | Mw/Mn | Optical purity (%ee) | Tm (°C) | Crystallinity (%) |
|---|---|---|---|---|---|---|---|
| | LA | L | 200,000 | 2.87 | 97 | 165.4 | 40.5 |
| | Thickness (μm) | MORc @50 μm | In-plane retardation (nm) | Bi-refringence | Internal haze (%) | Piezoelectric constant (pC/N) | MORc × Crystallinity |
| | 47.2 | 4.82 | 1028 | 0.0218 | 0.2 | 6.02 | 195 |

<Formation of surface layer>

A piezoelectric body that was the same as the piezoelectric body produced above, except that the thickness thereof was changed to a value set forth in the following Table 2, was prepared. A coating liquid was prepared by diluting an acrylic resin (OLESTER RA1353, produced by Mitsui Chemicals, Inc.; solid content concentration 82 mass %) with butyl acetate to a solid concentration of 40 mass %, and then mixing 1-hydroxycyclohexyl phenyl ketone (IRGACURE 184, produced by, BASF SE) as a photopolymerization initiator at 2 mass % with respect to the solid content. The coating liquid was coated on the piezoelectric body with an applicator, dried at 60°C for 5 min, and then irradiated with ultraviolet light from a metal halide lamp to an integral light quantity of 1,000 mJ/$cm^2$ to produce a cured product having a three-dimensional cross-linked structure formed by polymerization of the acrylic resin to form a surface layer and thus produce a layered body.

<Measurement of physical properties and evaluation>

Measurement of physical properties and evaluation of the layered body were carried out as follows.
The results are shown in the following Table 2.

- Thickness d of surface layer -

The thickness d of a surface layer was determined according to the following Formula using a digital length measuring machine DIGIMICRO STAND MS-11C, produced by Nikon Corporation.

$$d = dt\text{-}dp \qquad \text{Formula}$$

wherein,

dt: 10 point average thickness of the layered body
dp: 10 point average thickness of the piezoelectric body before formation of a surface layer

- Tensile modulus Ec of surface layer -

The tensile modulus Ec of a surface layer was calculated according to the following Formula.

Tensile modulus Ec of surface layer = [Tensile modulus of layered body – (Tensile modulus of lone piezoelectric body × Thickness of piezoelectric body / Thickness of layered body)] / (Thickness of surface layer / Thickness of layered body)

The "tensile modulus of layered body" in the above formula was measured by the following method.
The layered body was cut into a length of 120 mm in a direction 45° to the stretching direction (MD direction) of the crystalline polymeric piezoelectric body and into a length of 10 mm in a direction perpendicular to the 45° direction, to prepare a rectangular sample.
The obtained sample was set on a tensile testing machine (TENSILON RTG-1250, produced by A&D Company Ltd.) in which a distance between chucks was set to 70 mm so as not to loosen. A force was applied cyclically at a crosshead speed of 5 mm/min such that an applied force reciprocated between 4N and 9N to obtain a stress-strain relationship. From the obtained stress-strain relationship, a tensile modulus E was calculated.

$$\sigma = F/A$$

$$E = \Delta\sigma/\Delta\varepsilon$$

[$\sigma$: stress (Pa), F: applied force (N), A: cross section of layered body ($m^2$), $\Delta\sigma$: change in stress (Pa), and $\Delta\varepsilon$: change in

strain]

Further, the "Tensile modulus of lone piezoelectric body" was measured with respect to the piezoelectric body before formation of the surface layer in the same manner as the measurement of the tensile modulus of the layered body.

The measurement result of the tensile modulus of lone piezoelectric body was 3.70 GPa.

- Piezoelectric constant $d_{14}$ of layered body (by a stress-electric charge method) -

A measurement of the piezoelectric constant $d_{14}$ of the layered body was carried out in the same manner as the measurement of the piezoelectric constant $d_{14}$ of the piezoelectric body.

- Sensitivity change -

"Sensitivity change" means a change rate of a product of the piezoelectric constant "$d_{14}$ (layered body)" and the "tensile modulus E" of the layered body with respect to a product of the piezoelectric constant "$d_{14}$ (piezoelectric body)" (as described above 6.02 pC/N) and the "tensile modulus E" (as described above 3.70 GPa) of the lone piezoelectric body, namely [$d_{14}$ (layered body)×E (layered body)) / [$d_{14}$ (piezoelectric body)×E (piezoelectric body)].

[Example 2A, Comparative Example 1A]

A layered body of Example 2A was produced by forming a surface layer by producing a cured product having a three-dimensional cross-linked structure in the same manner as Example 1A, except that the thickness of the piezoelectric body and the thickness of the surface layer were changed to the values set forth in the following Table 2.

Similarly, a layered body of Comparative Example 1A was produced in the same manner as Example 1A, except that the thickness of the piezoelectric body and the thickness of the surface layer were changed to the values set forth in the following Table 2.

Measurements of the physical properties and evaluations with respect to the layered bodies were conducted in the same manner as Example 1A. The results are shown in the following Table 2.

[Comparative Example 2A]

A piezoelectric body that was the same as the piezoelectric body produced above, except that the thickness thereof was changed to a value set forth in the following Table 2, was prepared. A coating liquid was prepared by diluting an acrylic resin (OLESTER RA3091, produced by Mitsui Chemicals, Inc.; solid content concentration 67 mass %) with butyl acetate to a solid concentration of 40 mass %, and then mixing as a photopolymerization initiator 1-hydroxycyclohexyl phenyl ketone (IRGACURE 184, produced by, BASF SE) at 2 mass % with respect to the solid content. The coating liquid was coated on the piezoelectric body with an applicator, dried at 60°C for 5 min, and then irradiated with ultraviolet light from a metal halide lamp to an integral light quantity of 1,000 mJ/cm$^2$ to form a surface layer and produce a layered body. With respect to the obtained layered body, measurements of the physical properties and evaluation were conducted in the same manner as Example 1A. The results are shown in the following Table 2.

[Example 3A]

A piezoelectric body that was the same as the piezoelectric body produced above, except that the thickness thereof was changed to a value set forth in the following Table 2, was prepared. An acrylic resin (PELTRON A2002, produced by Pelnox Limited) was coated on the piezoelectric body with an applicator, dried at 60°C for 5 min, and then irradiated with ultraviolet light from a metal halide lamp to an integral light quantity of 1,000 mJ/cm$^2$ to form a surface layer by producing a cured product having a three-dimensional cross-linked structure by polymerizing the acrylic resin, thereby completing a layered body.

With respect to the obtained layered body, measurements of the physical properties and evaluation were conducted in the same manner as Example 1A. The results are shown in the following Table 2.

[Examples 4A to 6A]

A layered bodies of Examples 4A to 6A were produced by forming a surface layer by producing a cured product having a three-dimensional cross-linked structure by polymerizing the acrylic resin in the same manner as Example 3A, except that the thickness of the piezoelectric body, the material used for the surface layer, and the thickness of the surface layer were changed to those set forth in the following Table 2.

With respect to the obtained layered bodies measurements of the physical properties and evaluations were

conducted in the same manner as Example 1A. The results are shown in the following Table 2.

[Example 7A]

A piezoelectric body that was the same as the piezoelectric body produced above, except that the thickness thereof was changed to a value set forth in the following Table 2, was prepared. A coating liquid was prepared by diluting dipentaerythritol hexaacrylate (light curing monomer DPHA, produced by Shin-Nakamura Chemical Co., Ltd.) with butyl acetate to a solid concentration of 40 mass %, and then mixing as a photopolymerization initiator 1-hydroxycyclohexyl phenyl ketone (IRGACURE 184, produced by, BASF SE) at 2 mass % with respect to the solid content. The coating liquid was coated on the piezoelectric body with an applicator, dried at 60°C for 5 min, and then irradiated with ultraviolet light from a metal halide lamp to an integral light quantity of 1,000 mJ/cm$^2$ to form a surface layer by producing a cured product having a three-dimensional cross-linked structure by polymerizing the light curing monomer, thereby completing a layered body. With respect to the obtained layered body, measurements of the physical properties and evaluation were conducted in the same manner as Example 1A. The results are shown in the following Table 2.

[Table 2]

| | Piezoelectric body | Surface layer | | | | | Layered body | | | | |
|---|---|---|---|---|---|---|---|---|---|---|---|
| | Thickness (μm) | Material | Thickness d (μm) | Refractive index | Tensile modulus Ec (GPa) | Ec/d | Thickness (μm) | Tensile modulus E (GPa) | Piezoelectric constant $d_{14}$ (pC/N) | $d_{14} \times E$ | [Evaluation] Sensitivity change |
| Example 1A | 47.89 | RA1353 | 0.36 | 1.52 | 6.38 | 17.72 | 48.25 | 3.72 | 6.01 | 22.4 | 1.00 |
| Example 2A | 46.79 | RA1353 | 5.85 | 1.52 | 4.51 | 0.77 | 52.64 | 3.79 | 5.74 | 21.8 | 0.98 |
| Comparative Example 1A | 47.63 | RA1353 | 10.61 | 1.52 | 3.92 | 0.37 | 58.24 | 3.74 | 5.53 | 20.7 | 0.93 |
| Comparative Example 2A | 47.47 | RA3091 | 6.99 | 1.52 | 3.78 | 0.54 | 54.46 | 3.71 | 5.57 | 20.7 | 0.93 |
| Example 3A | 47.77 | A2002 | 4.23 | 1.53 | 4.31 | 1.02 | 52.00 | 3.75 | 5.84 | 21.9 | 0.98 |
| Example 4A | 47.98 | A2101 | 2.67 | 1.65 | 10.72 | 4.01 | 50.65 | 4.07 | 5.82 | 23.7 | 1.06 |
| Example 5A | 47.79 | A2101 | 7.47 | 1.65 | 6.51 | 0.87 | 55.26 | 4.08 | 5.56 | 22.7 | 1.02 |
| Example 6A | 46.10 | A2102 | 3.00 | 1.77 | 4.19 | 1.40 | 49.10 | 3.73 | 5.96 | 22.2 | 1.00 |
| Example 7A | 45.94 | DPHA | 4.74 | 1.51 | 3.81 | 0.80 | 50.68 | 3.71 | 5.89 | 21.9 | 0.98 |

The details of the materials shown in Table 2 are as follows.

- RA1353: acrylic resin, OLESTER RA1353, produced by Mitsui Chemicals, Inc.
- RA3091: acrylic resin, OLESTER RA3091, produced by Mitsui Chemicals, Inc.
- A2002: acrylic resin, PELTRON A2002, produced by Pelnox Limited
- A2101: acrylic resin, PELTRON A2101, produced by Pelnox Limited
- A2102: acrylic resin, PELTRON A2102, produced by Pelnox Limited
- DPHA: light curing monomer DPHA, produced by Shin-Nakamura Chemical Co., Ltd.

Fig. 1 is a graph showing a relationship between Ec / d and sensitivity change in Examples 1A to 7A and Comparative Examples 1A and 2A.

Fig. 2 is a graph showing an Ec / d range of from 0 to 1.5 in Fig. 1.

As shown in Table 2, Fig. 1, and Fig. 2, with respect to Examples 1A to 7A, in which Ec / d was 0.6 or more, the values of sensitivity change were remarkably higher compared to Comparative Examples 1A and 2A, in which Ec / d was less than 0.6. In other words, in the case of Examples 1 A to 7A, in which Ec / d was 0.6 or more, decrease in the sensitivity due to placement of a surface layer was remarkably suppressed compared to Comparative Examples 1A and 2A, in which Ec / d was less than 0.6.

<Examples of the second aspect>

Examples of the second aspect (Examples 1 B to 21 B) and Comparative Examples (Comparative Examples 1 B to 4B) will be described.

<Production of piezoelectric body>

(Production of piezoelectric body (P1))

To 100 parts by mass of poly(lactic acid) (Registered trademark LACEA, H-400 produced by Mitsui Chemicals, Inc.; weight-average molecular weight Mw: 200,000), 1.0 part by mass of a stabilizer (Trade name STABAXOL I produced by Rhein Chemie Rheingau GmbH; bis-2,6-diisopropylphenyl carbodiimide) was added and blended in a dry state to prepare a source material. The prepared source material was charged into a hopper of an extruder, which was then extruded with heating at from 220°C to 230°C through a T-die, and brought into contact with a cast roll at 50°C for 0.3 min to form a 150 μm-thick pre-crystallized sheet (pre-crystallization step). The crystallinity of the pre-crystallized sheet was measured to find 6%.

The obtained pre-crystallized sheet was stretched uniaxially 3.5-fold simultaneously with heating at 70°C in the MD direction-by a roll-to-roll method at an initial stretching speed of 3 m/min (stretching step). The thickness of the obtained film was 47.2 μm.

Then the uniaxially stretched film was contacted with rolls heated to 145°C by a roll-to-roll method for 15 sec to perform an annealing treatment, and quenched to produce a piezoelectric body (P1) which was the crystalline polymeric piezoelectric body (piezoelectric body) (annealing treatment step).

- Measurement of amounts of L-form and D-form of polymer (poly(lactic acid)) -

The amounts of L-form and D-form of a polymer (poly(lactic acid)) contained in the crystalline polymeric piezoelectric body were measured by the same method as described in Example 1 A. The optical purity (%ee) was calculated form the obtained results. The results are shown in the following Table 3.

In the following Table 3 and Table 6, "LA" stands for poly(lactic acid).

<Weight-average molecular weight and molecular weight distribution>

The weight-average molecular weight (Mw) and the molecular weight distribution (Mw/Mn) of a polymer (poly(lactic acid)) contained in the crystalline polymeric piezoelectric body was measured using the same GPC measuring method as described in Example 1A.

The results are shown in the following Table 3.

<Measurement of physical properties and evaluation>

With respect to the piezoelectric body (P1), the melting point Tm, crystallinity, thickness, internal haze, piezoelectric constant, standardized molecular orientation MORc, in-plane retardation, and birefringence were measured respectively by the same methods as described in Example 1 A.

The results are shown in Table 3.

(Production of piezoelectric body (P2))

A piezoelectric body (P2), which was the crystalline polymeric piezoelectric body (piezoelectric body), was produced by the same method as for the piezoelectric body (P1), except that, in the stretching step, the stretching method of uniaxial stretching in the production of the piezoelectric body (P1) was changed to simultaneous biaxial stretching, wherein the stretch ratio in the MD direction was 1.5-fold, the stretch ratio in the TD direction was 4.4-fold, the stretching speed was 8 m/min, and the pre-crystallized sheet temperature was 80°C.

The measurement results of various physical properties are shown in the following Table 3.

(Production of piezoelectric body (B))

A piezoelectric body (B), which was the crystalline polymeric piezoelectric body (piezoelectric body), was produced similarly as the production of the piezoelectric body (P1), except that a stretching step and an annealing treatment step were not performed, and an obtained pre-crystallized sheet was heated in an oven at 110°C for 30 min.

The measurement results of various physical properties are shown in the following Table 3.

(Production of piezoelectric body (C))

As a piezoelectric body (C) (crystalline polymeric piezoelectric body), PALGREEN LC (Product name of a biaxially stretched film / Same stretch ratio in MD direction and TD direction, produced by Mitsui Chemicals Tohcello, Inc.) was used.

The measurement results of various physical properties are shown in the following Table 3.

[Table 3]

| | Piezoelectric body | | | |
|---|---|---|---|---|
| | P1 | P2 | B | C |
| Polymer | LA | LA | LA | - |
| Chirality | L | L | L | - |
| Mw | 200,000 | 200,000 | 200,000 | - |
| Mw/Mn | 2.87 | 2.87 | 2.87 | - |
| Optical purity (%ee) | 97.0 | 97.0 | 97.0 | - |
| Tm (°C) | 165.4 | 165.2 | 166.3 | 165.6 |
| Crystallinity (%) | 40.5 | 35.9 | 35.2 | 39.3 |
| Thickness (μm) | 47.2 | 36.0 | 342.4 | 15.4 |
| MORc [50 μm] | 4.82 | 4.18 | 1.05 | 1.78 |
| In-plane retardation (nm) | 1028 | 756 | unmeasurable | 115 |
| Birefringence | 0.0218 | 0.0210 | unmeasurable | 0.0075 |
| Internal haze (%) | 0.2 | 0.1 | 80.2 | 0.6 |
| Piezoelectric constant (pC/N) | 6.02 | 5.20 | unmeasurable | unmeasurable |
| MORc × Crystallinity | 195 | 150 | 37 | 70 |

[Example 1B]

<Formation of surface layer>

A piezoelectric body that was the same as the piezoelectric body (P1) produced above, except that the thickness

thereof was changed to a value set forth in the following Table 4, was prepared. A coating liquid was prepared by diluting an acrylic resin (OLESTER RA1353, produced by Mitsui Chemicals, Inc.; solid content concentration 82 mass %) with butyl acetate to a solid concentration of 40 mass %, and then mixing as a photopolymerization initiator 1-hydroxycyclohexyl phenyl ketone (IRGACURE 184, produced by, BASF SE) at 2 mass % with respect to the solid content. The coating liquid was coated on the piezoelectric body with an applicator, dried at 60°C for 5 min, and then irradiated with ultraviolet light from a metal halide lamp to an integral light quantity of 1,000 mJ/cm$^2$ to produce a polymer having a three-dimensional cross-linked structure formed by polymerization of the acrylic resin to form a surface layer and thus produce a layered body.

<Measurement of physical properties and evaluation>

Measurement of physical properties and evaluation of the layered body were carried out as follows.
The results are shown in the following Table 4.

- Thickness d of surface layer -

The thickness d of the surface layer was determined according to the following Formula using a digital length measuring machine DIGIMICRO STAND MS-11C, produced by Nikon Corporation.

$$d = dt\text{-}dp \qquad \text{Formula}$$

wherein,

dt: 10 point average thickness of the layered body
dp: 10 point average thickness of the piezoelectric body before formation of the surface layer

- Evaluation of adherence between piezoelectric body and surface layer -

For evaluation of adherence, 6 cut lines are made in the surface layer with a cutter knife from above at 2 mm intervals in a longitudinal direction and a cross direction respectively to form 25 grid patterns in a size of 2 mm square, then a cellophane adhesive tape (produced by Nichiban Co., Ltd.) was stuck tightly thereon, and pulled off rapidly by hand. If no grid pattern was peeled, it was rated "A", and if even a part of the same was peeled, it was rated "B".

[Examples 2B to 7B, 13B, and 14B]

Layered bodies of Examples 2B to 7B, 13B, and 14B were produced by forming a surface layer by producing a polymeride having a three-dimensional cross-linked structure formed by polymerization of an acrylic resin in the same manner as Example 1 B, except that the kind of the piezoelectric body, the thickness of the piezoelectric body, the material used for the surface layer, and the thickness of the surface layer were changed to those set forth in the following Table 4.
With respect to the obtained layered bodies, measurements of the physical properties and evaluation were conducted in the same manner as Example 1B. The results are shown in the following Table 4.

[Example 8B]

A piezoelectric body identical with the piezoelectric body (P1) produced as above was prepared except that the thickness thereof was changed to the value set forth in the following Table 4. An acrylic resin (PELTRON A2002, produced by Pelnox Limited) was coated on the piezoelectric body with an applicator, dried at 60°C for 5 min, and then irradiated with ultraviolet light from a metal halide lamp to an integral light quantity of 1,000 mJ/cm$^2$ to produce a polymeride having a three-dimensional cross-linked structure formed by polymerization of the acrylic resin to form a surface layer and thus produce a layered body of Example 8B.
With respect to the obtained layered body, measurements of the physical properties and evaluation were conducted in the same manner as Example 1B. The results are shown in the following Table 4.

[Examples 9B and 10B]

Layered bodies of Examples 9B and 10B were produced by forming a surface layer by producing a polymeride

having a three-dimensional cross-linked structure formed by polymerization of an acrylic resin in the same manner as Example 8B, except that the thickness of the piezoelectric body, the material used for the surface layer, and the thickness of the surface layer were changed to those set forth in the following Table 4.

With respect to the obtained layered bodies, measurements of the physical properties and evaluation were conducted in the same manner as Example 1 B. The results are shown in the following Table 4.

[Example 11B]

A piezoelectric body that was the same as the piezoelectric body (P1) produced above, except that the thickness thereof was changed to a value set forth in the following Table 4, was prepared. An acrylic resin (SEIKABEAM EXF-01, produced by Dainichiseika Color & Chemicals Mfg. Co., Ltd.) was coated on the piezoelectric body with an applicator, dried at 60°C for 5 min, and then irradiated with ultraviolet light from a metal halide lamp to an integral light quantity of 1,000 $mJ/cm^2$ to produce a polymeride having a three-dimensional cross-linked structure formed by polymerization of the acrylic resin to form a surface layer and thus produce a layered body of Example 11 B.

With respect to the obtained layered body, measurements of the physical properties and evaluation were conducted in the same manner as Example 1B. The results are shown in the following Table 4.

[Example 12B]

A piezoelectric body that was the same as the piezoelectric body (P1) produced above, except that the thickness thereof was changed to a value set forth in the following Table 4, was prepared. A coating liquid was prepared by diluting dipentaerythritol hexaacrylate (light curing monomer A-DPH, produced by Shin-Nakamura Chemical Co., Ltd.) with butyl acetate to a solid concentration of 40 mass %, and then mixing as a photopolymerization initiator 1-hydroxycyclohexyl phenyl ketone (IRGACURE 184, produced by, BASF SE) at 2 mass % with respect to the solid content. The coating liquid was coated on the piezoelectric body with an applicator, dried at 60°C for 5 min, and then irradiated with ultraviolet light from a metal halide lamp to an integral light quantity of 1,000 $mJ/cm^2$ to produce a polymeride having a three-dimensional cross-linked structure formed by polymerization of the light curing monomer to form a surface layer and thus produce a layered body of Example 12B.

With respect to the obtained layered body, measurements of the physical properties and evaluation were conducted in the same manner as Example 1B. The results are shown in the following Table 4.

[Comparative Examples 1B and 2B]

Layered bodies of Comparative Examples 1B and 2B were produced by forming a surface layer by producing a polymeride having a three-dimensional cross-linked structure formed by polymerization of an acrylic resin in the same manner as Example 1 B, except that the kind of the piezoelectric body, the thickness of the piezoelectric body, and the thickness of the surface layer were changed to those set forth in Table 4.

With respect to the obtained layered bodies, measurements of the physical properties and evaluation were conducted in the same manner as Example 1B. The results are shown in the following Table 4.

[Comparative Example 3B]

A piezoelectric body that was the same as the piezoelectric body (P1) produced above, except that the thickness thereof was changed to a value set forth in the following Table 4, was prepared. A coating liquid was prepared by mixing 720 parts by mass of water, 1,080 parts by mass of 2-propanol, and 46 parts by mass of acetic acid, to which 480 parts by mass of γ-glycidoxypropyltrimethoxysilane (Trade name "KBM403", produced by Shin-Etsu Chemical Co., Ltd.), 240 parts by mass of methyltrimethoxysilane (Trade name "KBM13", produced by Shin-Etsu Chemical Co., Ltd.), and 120 parts by mass of *N*-β-(aminoethyl)-γ-aminopropyltrimethoxysilane (Trade name "KBM603", produced by Shin-Etsu Chemical Co., Ltd.) were added successively, and by stirring the mixture liquid for 3 hours allowing the 3 kinds of alkoxysilanes to be hydrolyzed or partly condensed. The coating liquid was coated on the piezoelectric body with an applicator, heated at 130°C for 10 min to produce a polymeride having a three-dimensional cross-linked structure to form a surface layer and thus produce a layered body of Comparative Example 3B.

With respect to the obtained layered body, measurements of the physical properties and evaluation were conducted in the same manner as Example 1B. The results are shown in the following Table 4.

[Comparative Example 4B]

A layered body of Comparative Examples 4B was produced by forming a surface layer by producing a silane-type cured product in the same manner as Comparative Example 3B, except that the kind of the piezoelectric body, the thickness of the piezoelectric body, and the thickness of the surface layer were changed to those set forth in the following Table 4.

With respect to the obtained layered body, measurements of the physical properties and evaluation were conducted in the same manner as Example 1B. The results are shown in the following Table 4.

[Table 4]

| | Piezoelectric body | | Surface layer | | | Layered body | Evaluation |
|---|---|---|---|---|---|---|---|
| | Kind | Thickness (μm) | Material | | Thickness (μm) | Thickness (μm) | Adherence |
| Example 1B | P1 | 47.89 | RA1353 | acrylic | 0.36 | 48.25 | A |
| Example 2B | P1 | 46.79 | RA1353 | acrylic | 5.85 | 52.64 | A |
| Example 3B | P1 | 47.63 | RA1353 | acrylic | 10.61 | 58.24 | A |
| Example 4B | P1 | 47.47 | RA3091 | acrylic | 6.99 | 54.46 | A |
| Example 5B | P1 | 47.62 | RA4040 | acrylic | 2.72 | 50.34 | A |
| Example 6B | P1 | 46.41 | RA5000 | acrylic | 6.17 | 52.58 | A |
| Example 7B | P1 | 45.89 | RA6800 | acrylic | 7.01 | 52.90 | A |
| Example 8B | P1 | 47.77 | A2002 | acrylic | 4.23 | 52.00 | A |
| Example 9B | P1 | 47.98 | A2101 | acrylic | 2.67 | 50.65 | A |
| Example 10B | P1 | 46.10 | A2102 | acrylic | 3.00 | 49.10 | A |
| Example 11 B | P1 | 47.36 | EXF-01 | acrylic | 2.27 | 49.63 | A |
| Example 12B | p1 | 45.94 | A-DPH | acrylic | 4.74 | 50.68 | A |
| Example 13B | P2 | 36.00 | RA1353 | acrylic | 4.50 | 40.50 | A |
| Example 14B | P1 | 46.46 | RA1353 | acrylic | 4.88 | 51.34 | A |
| Comparative Example 1B | B | 342.40 | RA1353 | acrylic | 5.90 | 348.30 | B |
| Comparative Example 2B | C | 15.40 | RA1353 | acrylic | 3.00 | 18.40 | B |
| Comparative Example 3B | P1 | 46.64 | silane-type cured product | | 2.13 | 48.77 | B |
| Comparative Example 4B | C | 15.20 | silane-type cured product | | 2.25 | 17.45 | B |

The details of the materials shown in Table 4 are as follows.

- RA1353: acrylic resin, OLESTER RA1353, produced by Mitsui Chemicals, Inc.
- RA3091: acrylic resin, OLESTER RA3091, produced by Mitsui Chemicals, Inc.
- RA4040: acrylic resin, OLESTER RA4040, produced by Mitsui Chemicals, Inc.
- RA5000: acrylic resin, OLESTER RA5000, produced by Mitsui Chemicals, Inc.
- RA6800: acrylic resin, OLESTER RA6800, produced by Mitsui Chemicals, Inc.
- A2002: acrylic resin, PELTRON A2002, produced by Pelnox Limited
- A2101: acrylic resin, PELTRON A2101, produced by Pelnox Limited

- A2102: acrylic resin, PELTRON A2102, produced by Pelnox Limited
- EXF-01: acrylic resin, SEIKABEAM EXF-01, produced by Dainichiseika Color & Chemicals Mfg. Co., Ltd.
- A-DPH: light curing monomer DPHA, produced by Shin-Nakamura Chemical Co., Ltd.
- Silane-type cured product: γ-glycidoxypropyltrimethoxysilane, methyltrimethoxysilane, and *N*-β-(aminoethyl)-γ-aminopropyltrimethoxysilane

As shown in Table 4, layered bodies of Examples 1B to 14B were superior in adherence between a piezoelectric body and a surface layer.

With respect to layered bodies of Examples 1B, 2B, 5B, 6B, and 8B to 14B, by a method described in Example 1A, the tensile modulus Ec of the surface layer was measured, and the ratio (Ec/d) of the tensile modulus Ec of the surface layer to the thickness d of the surface layer was determined to rate the sensitivity change. The results are shown in the following Table 5.

[Table 5]

| | Surface layer | | | Layered body |
|---|---|---|---|---|
| | Thickness d (μm) | Tensile modulus Ec | Ec / d | [Evaluation] Sensitivity |
| | | (GPa) | | change |
| Example 1B | 0.36 | 6.38 | 17.72 | 1.00 |
| Example 2B | 5.85 | 4.51 | 0.77 | 0.98 |
| Example 5B | 2.72 | 4.28 | 1.57 | 1.01 |
| Example 6B | 6.17 | 3.75 | 0.61 | 0.98 |
| Example 8B | 4.23 | 4.31 | 1.02 | 0.98 |
| Example 9B | 2.67 | 10.72 | 4.01 | 1.06 |
| Example 10B | 3.00 | 4.19 | 1.40 | 1.00 |
| Example 11B | 2.27 | 5.78 | 2.55 | 1.00 |
| Example 12B | 4.74 | 3.81 | 0.80 | 0.98 |
| Example 13B | 4.50 | 4.61 | 1.02 | 0.99 |
| Example 14B | 4.88 | 4.19 | 0.86 | 0.97 |

As shown in Table 5, in Examples 1B, 2B, 5B, 6B, and 8B to 14B, $0.6 \leq Ec / d$ was satisfied, and decrease in the sensitivity due to placement of a surface layer was remarkably suppressed similarly to Example 1A, *etc.*

As obvious from the above, Examples 1B, 2B, 5B, 6B, and 8B to 14B come not only under an Example of the second aspect, but also under an Example of the first aspect.

[Example 15B]

[Production of piezoelectric body (P3)]

Firstly, 0.01 part by mass of FS Blue 1504 as a bluing agent was added to 100 parts by mass of poly(lactic acid) (Product name: INGEO TM biopolymer, Grade No.: 4032D, produced by NatureWorks LLC; weight-average molecular weight (Mw): 200,000, melting point (Tm): 166°C, glass transition temperature (Tg): 57 to 60°C), and the mixture was blended in a dry state, and kneaded in a twin screw extruder to prepare a masterbatch containing the bluing agent.

Next, to 94 parts by mass of the poly(lactic acid) "4032D", 5 parts by mass of the masterbatch containing the bluing agent, and 1.0 part by mass of a stabilizer, which was a mixture of 10 parts by mass of STABAXOL P400, produced by Rhein Chemie Rheingau GmbH, 70 parts by mass of STABAXOL I, produced by Rhein Chemie Rheingau GmbH, and 20 parts by mass of CARBODILITE LA-1 produced by Nisshinbo Chemical Inc., was added, followed by dry blending to prepare a source material.

The prepared source material was charged into a hopper of an extruder, which was then extruded with heating at 210°C through a T-die, and brought into contact with a cast roll at 50°C for 0.3 min to form a 150 μm-thick pre-crystallized sheet (pre-crystallization step). The crystallinity of the pre-crystallized sheet was measured to find 6%.
Stretching of the produced pre-crystallized sheet was started at a stretching speed of 10 m/min by roll-to-roll with heating at 70°C and continued up to 3.5-fold uniaxially in the MD direction (stretching step). The thickness of the obtained film was 49.2 μm.
Then the uniaxially stretched film was contacted with a roll heated to 145 °C for 15 sec by roll-to-roll to perform an annealing treatment, and thereafter quenched to produce a piezoelectric body (P3) which was the crystalline polymeric piezoelectric body (piezoelectric body) (annealing treatment step).
With respect to the obtained layered body (P3), measurements of various physical properties were conducted in the same manner as the piezoelectric body (P1). The measurement results of various physical properties are shown in the following Table 6.

[Table 6]

| | Piezoelectric body |
|---|---|
| | P3 |
| Polymer | LA |
| Chirality | L |
| Mw | 200,000 |
| Mw/Mn | 2.87 |
| Optical purity (%ee) | 97.0 |
| Tm (°C) | 165.4 |
| Crystallinity (%) | 41.8 |
| Thickness (μm) | 49.2 |
| MORc [50 μm] | 4.72 |
| In-plane retardation (nm) | 1028 |
| Birefringence | 0.0209 |
| Internal haze (%) | 0.2 |
| Piezoelectric constant (pC/N) | 6.39 |
| MORc × Crystallinity | 197 |

<Formation of surface layer>

A piezoelectric body that was the same as the piezoelectric body (P3), except that the thickness thereof was changed to a value set forth in the following Table 7, was prepared. An acrylic resin coating liquid (anti-block hard coat LIODURAS TYAB-014, produced by Toyo Ink Co., Ltd.) was coated on the piezoelectric body with an applicator, dried at 60°C for 5 min, and then irradiated with ultraviolet light from a high pressure mercury lamp (no filter) to an integral light quantity of 1,000 mJ/cm$^2$ to form a surface layer by producing a polymeride cured product having a three-dimensional cross-linked structure by polymerizing the acrylic resin, thereby completing a layered body of Example 15B.
With respect to the obtained layered body, measurements of the physical properties and evaluation of were conducted in the same manner as Example 1B. The results are shown in the following Table 7.

<Measurement of acrylic terminal ratio of polymer contained in piezoelectric body>

A piezoelectric body was obtained by removing the surface layer from the layered body of the Example 15B by grinding the surface layer side of the layered body of Example 15B with a sand paper such that the thickness of the polishing object became equal to the thickness of the lone piezoelectric body
With respect to the obtained piezoelectric body, the acrylic terminal ratio of a polymer contained in the piezoelectric body was measured. The details will be described below.

A 20 mg-sample was taken from the piezoelectric body obtained by removing the surface layer, and dissolved in 0.6 mL of deuterated chloroform (chloroform-d) to obtain a sample solution for a $^1$H-NMR spectrum measurement.

A $^1$H-NMR spectrum was measured on the obtained sample solution under the following measurement conditions.

- Measurement conditions for $^1$H-NMR spectrum -

Measuring apparatus: ECA-500 produced by JEOL Ltd. (proton-nuclear resonance frequency 500 MHz)
Solvent: deuterated chloroform (chloroform-d)
Measurement temperature: room temperature
Pulse angle: 45°
Pulse interval: 6.53 sec
Integration frequency: 512 times

In the measured $^1$H-NMR spectrum, peaks derived from 3 protons of each acrylic terminal (each acryloyl group) were observed at positions of $\delta$ 5.9 ppm, $\delta$ 6.1 ppm, and $\delta$ 6.4 ppm, and a peak derived from protons of methine groups in main chains of a polymer at a position of $\delta$ 5.1 ppm, respectively in a high resolution.

Next, an average value of integral values of the respective peaks at $\delta$ 5.9 ppm, $\delta$ 6.1 ppm, and $\delta$ 6.4 ppm was determined as the integral value of the peak derived from acrylic terminals of the polymer. Further, an integral value of the peak at $\delta$ 5.1 ppm was determined as the integral value of the peak derived from methine groups in main chains of the polymer.

The ratio of acrylic terminals (acryloyl groups) of the polymer contained in the piezoelectric body (the crystalline polymeric piezoelectric body) was calculated based on the results according to the above Formula (X).

The results are shown in the following Table 7.

<Evaluation of moist heat resistance>

The layered body of Example 15B was cut into a 50 mm$\times$50 mm square to produce a specimen. Two specimens were produced (hereinafter referred to as "Specimen 1" and "Specimen 2").

With respect to Specimen 1, the molecular weight Mw was measured similarly as a "GPC measuring method", and the measured value was defined as "Mw before test".

Specimen 2 was suspended in a thermo-hygrostat kept at 85°C and RH85% and maintained there for 192 hours (moist heat resistance test), and then taken out of the thermo-hygrostat. With respect to the taken out Specimen 2, the molecular weight Mw was measured similarly as a "GPC measuring method", and the measured value was defined as "Mw after moist heat resistance test".

Based on the Mw before test and the Mw after moist heat resistance test, the moist heat resistance was rated according to the following criteria.

The results are shown in the following Table 7.

- Criteria -

A: Mw after moist heat resistance test / Mw before test = Not less than 0.7
B: Mw after moist heat resistance test / Mw before test = Less than 0.7, but not less than 0.4
C: Mw after moist heat resistance test / Mw before test = Less than 0.4

<Evaluation of tear strength>

The tear strength of the layered body of Example 15B was measured as follows.

Firstly, as shown in Fig. 3, a specimen 12 for a tear strength measurement (specimen stipulated according to JIS K 7128-3 (1998)) was cut out from a film 10, which was the layered body of Example 15B. In this case, the specimen 12 was cut out, such that the longitudinal direction of the same was parallel to the TD direction of the film 10 as shown in Fig. 3.

Next, with respect to the cut-out specimen 12, the tear strength was measured according to a "Right angled tear method" of JIS K 7128-3(1998) by tearing the specimen 12 at a central part in the longitudinal direction of the same in the MD direction of the film.

In this case the crosshead speed of a tensile testing machine was 200 mm/min and the tear strength was

calculated according to the following formula.

$$T = F / d$$

In the formula, T stands for tear strength (N/mm), F for maximum tearing load, and d for thickness of specimen (mm).
maximum tearing load

The results are shown in the following Table 7.

[Example 16B]

A layered body of Example 16B was produced by forming a surface layer by producing a polymeride cured product having a three-dimensional cross-linked structure formed by polymerization of an acrylic resin in the same manner as Example 15B, except that the thickness of the piezoelectric body, and the thickness of the surface layer of Example 15B were changed to those set forth in the following Table 7.

With respect to the obtained layered body, measurements of the physical properties and evaluation were conducted in the same manner as Example 15B.

The results are shown in the following Table 7.

[Example 17B]

A layered body of Example 17B was produced by forming a surface layer by producing a polymeride cured product having a three-dimensional cross-linked structure formed by polymerization of an acrylic resin in the same manner as Example 15B, except that a filter (TEMPAX, thickness 2 mm, produced by Scott AG) was attached to a high pressure mercury lamp for screening ultraviolet light with specific wavelength, and the thickness of the piezoelectric body, and the thickness of the surface layer of Example 15B were changed to those set forth in the following Table 7.

With respect to the obtained layered body, measurements of the physical properties and evaluation were conducted in the same manner as Example 15B.

The results are shown in the following Table 7.

[Example 18B]

A layered body of Example 18B was produced by forming a surface layer by producing a polymeride cured product having a three-dimensional cross-linked structure formed by polymerization of an acrylic resin in the same manner as Example 15B, except that a light source was changed to an electrodeless H bulb, and the thickness of the piezoelectric body, and the thickness of the surface layer of Example 15B were changed to those set forth in the following Table 7.

With respect to the obtained layered body, measurements of the physical properties and evaluation were conducted in the same manner as Example 15B.

The results are shown in the following Table 7.

[Example 19B]

A layered body of Example 19B was produced by forming a surface layer by producing a polymeride cured product having a three-dimensional cross-linked structure formed by polymerization of an acrylic resin in the same manner as Example 18B, except that a filter (TEMPAX, thickness 2 mm, produced by Scott AG) was attached to an electrodeless H bulb for screening ultraviolet light with specific wavelength, and the thickness of the piezoelectric body, and the thickness of the surface layer of Example 18B were changed to those set forth in the following Table 7.

With respect to the obtained layered body, measurements of the physical properties and evaluation were conducted in the same manner as Example 18B.

The results are shown in the following Table 7.

[Example 20B]

A layered body of Example 20B was produced by forming a surface layer by producing a polymeride cured product having a three-dimensional cross-linked structure formed by polymerization of an acrylic resin in the same

manner as Example 15B, except that an UV absorber TINUVIN 120 (produced by BASF SE) was added to the acrylic resin coating liquid (TYAB-014) to a solid content concentration of 1 wt%, and the thickness of the piezoelectric body, and the thickness of the surface layer of Example 15B were changed to those set forth in the following Table 7.

With respect to the obtained layered body, measurements of the physical properties and evaluation were conducted in the same manner as Example 15B.

The results are shown in the following Table 7.

[Example 21B]

A layered body of Example 21B was produced by forming a surface layer by producing a polymeride cured product having a three-dimensional cross-linked structure formed by polymerization of an acrylic resin in the same manner as Example 20B, except that the addition amount of TINUVIN 120 (produced by BASF SE) was changed to a solid content concentration of 10 wt%, and the thickness of the piezoelectric body, and the thickness of the surface layer of Example 20B were changed to those set forth in the following Table 7.

With respect to the obtained layered body, measurements of the physical properties and evaluation were conducted in the same manner as Example 20B.

The results are shown in the following Table 7.

[Table 7]

| | Piezoelectric body | | Surface layer | | | Layered body | Ultraviolet light irradiation | Adherence | Ratio of acrylic terminals | Moist heat resistance | Tear strength [N/mm] |
|---|---|---|---|---|---|---|---|---|---|---|---|
| | Kind | Thickness (μm) | Material | | Thickness (μm) | Thickness (μm) | Light source / Filter | | | | |
| Example 15B | P3 | 48.23 | TYAB-014 | acrylic | 4.15 | 52.38 | High pressure mercury lamp /No | A | $6.26\times10^{-5}$ | A | 32.9 |
| Example 16B | P3 | 47.84 | TYAB-014 | acrylic | 1.93 | 49.77 | High pressure mercury lamp /No | A | $15.1\times10^{-5}$ | C | 17.8 |
| Example 17B | P3 | 48.11 | TYAB-014 | acrylic | 1.98 | 50.09 | High pressure mercury lamp /Yes | A | $7.89\times10^{-5}$ | A | 35.3 |
| Example 18B | P3 | 47.98 | TYAB-014 | acrylic | 2.14 | 50.12 | Eelectrodeless H bulb /No | A | $17.4\times10^{-5}$ | C | 23.3 |
| Example 19B | P3 | 48.31 | TYAB-014 | acrylic | 1.76 | 50.07 | Eelectrodeless H bulb / Yes | A | $6.83\times10^{-5}$ | A | 33.8 |
| Example 20B | P3 | 49.17 | TYAB-014 +TINUVIN1% | acrylic | 2.26 | 51.43 | High pressure mercury lamp / No | A | $16.2\times10^{-5}$ | C | 24.7 |
| Example 21B | P3 | 47.67 | TYAB-014 +TINUVIN10% | acrylic | 1.98 | 49.65 | High pressure mercury lamp /No | A | $13.4\times10^{-5}$ | C | 21.6 |

As shown in Table 7, layered bodies of Examples 15B to 21B were superior in adherence between a piezoelectric body and a surface layer similarly to layered bodies of Examples 1B to 14B.

Among layered bodies of Examples 15B to 21B, especially those of Examples 15B, 17B, and 19B, in which the acrylic terminal ratio of a polymer (poly(lactic acid)) contained in a piezoelectric body is within the range of from $2.0\times10^{-5}$ to $10.0\times10^{-5}$, were also superior in moist heat resistance and tear strength.

Next, with respect to layered bodies of Examples 15B to 21 B, the tensile modulus Ec of the surface layer was measured by a method described in Example 1A, and the ratio of the tensile modulus Ec of the surface layer to the thickness d of a surface layer [Ec / d] was determined, to rate the sensitivity change. The results are shown in the following Table 8.

[Table 8]

| | Surface layer | | | Layered body |
|---|---|---|---|---|
| | Thickness d (μm) | Tensile modulus Ec (GPa) | Ec/d | [Evaluation] Sensitivity change |
| Example 15B | 4.15 | 4.69 | 1.13 | 0.97 |
| Example 16B | 1.93 | 5.15 | 2.67 | 0.99 |
| Example 17B | 1.98 | 4.96 | 2.51 | 1.00 |
| Example 18B | 2.14 | 5.37 | 2.51 | 1.01 |
| Example 19B | 1.76 | 5.91 | 3.36 | 1.00 |
| Example 20B | 2.26 | 5.88 | 2.60 | 0.99 |
| Example 21B | 1.98 | 5.56 | 2.81 | 1.00 |

As shown in Table 8, in Examples 15B to 21B, $0.6 \leq Ec / d$ was satisfied, and decrease in the sensitivity due to placement of a surface layer was remarkably suppressed similarly to Example 1A, *etc.*

As obvious from the above, Examples 15B to 21B correspond to not only an Example of the second aspect, but also an Example of the first aspect.

The entire disclosure of Japanese Patent Applications No. 2013-082392 filed on 10 April 2013, Japanese Patent Applications No. 2013-090766 filed on 23 April 2013, and Japanese Patent Applications No. 2014-022550 filed on 7 February 2014 are incorporated herein by reference.

All publications, patent applications, and technical standards described in this specification are herein incorporated by reference to the same extent as if each individual publication, patent application, or technical standard was specifically and individually indicated to be incorporated by reference.

## Claims

**1.** A layered body comprising:

a crystalline polymeric piezoelectric body having a molecular orientation, and
a surface layer in which a relationship between a tensile modulus Ec (GPa) and a thickness d (μm) satisfies the following Formula (A):

$$0.6 \leq Ec / d \qquad \text{Formula (A).}$$

**2.** The layered body according to claim 1, wherein Ec / d in Formula (A) is 36 or less.

**3.** The layered body according to claim 1 or claim 2, wherein the thickness d of the surface layer is from 0.01 μm to 10 μm.

**4.** The layered body according to claim 1 or claim 2, wherein the tensile modulus Ec of the surface layer is from 0.1 GPa to 1,000 GPa.

**5.** The layered body according to claim 1 or claim 2, wherein the surface layer comprises at least one kind of material

selected from the group consisting of an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acrylic hybrid compound, a silica-epoxy hybrid compound, a metal, and a metallic oxide.

**6.** The layered body according to claim 1, wherein a standardized molecular orientation MORc of the crystalline polymeric piezoelectric body, measured by a microwave transmission molecular orientation meter based on a reference thickness of 50 μm, is from 2.0 to 10.0,
and wherein the surface layer is placed so that at least a part thereof contacts the crystalline polymeric piezoelectric body, and comprises a carbonyl group and a polymeride.

**7.** The layered body according to claim 1 or claim 2, wherein the surface layer comprises a material having a three-dimensionally cross-linked structure.

**8.** The layered body according to claim 1 or claim 2, wherein an internal haze for visible light of the crystalline polymeric piezoelectric body is 50% or less,
and wherein a piezoelectric constant $d_{14}$ of the crystalline polymeric piezoelectric body measured at 25°C by a stress-electric charge method is 1 pC/N or more.

**9.** The layered body according to claim 1 or claim 2, wherein an internal haze of the crystalline polymeric piezoelectric body with respect to visible light is 13% or less.

**10.** The layered body according to claim 1 or claim 2, wherein a product of a standardized molecular orientation MORc of the crystalline polymeric piezoelectric body measured by a microwave transmission molecular orientation meter based on a reference thickness of 50 μm and a crystallinity of the crystalline polymeric piezoelectric body measured by a DSC method is from 40 to 700.

**11.** The layered body according to claim 1 or claim 2, wherein the crystalline polymeric piezoelectric body comprises a polymer including a repeating unit structure having at least one functional group of a carbonyl group or an oxy group.

**12.** The layered body according to claim 1, wherein the crystalline polymeric piezoelectric body comprises a helical chiral polymer having optical activity with a weight-average molecular weight of from 50,000 to 1,000,000, and has a crystallinity measured by a DSC method of from 20% to 80%.

**13.** The layered body according to claim 12, wherein the helical chiral polymer is a poly(lactic acid)-type polymer having a main chain including a repeating unit represented by the following Formula (1):

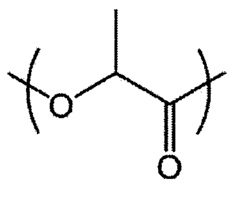

(1)

.

**14.** The layered body according to claim 12 or claim 13, wherein an optical purity of the helical chiral polymer is 95.00%ee or more.

**15.** The layered body according to claim 12 or claim 13, wherein a content of the helical chiral polymer in the crystalline polymeric piezoelectric body is 80 mass % or more.

**16.** The layered body according to claim 12 or claim 13, wherein the crystalline polymeric piezoelectric body contains a stabilizer with a weight-average molecular weight of from 200 to 60,000 having at least one kind of functional group selected from the group consisting of a carbodiimide group, an epoxy group, and an isocyanate group, and wherein the stabilizer is contained at from 0.01 part by mass to 10 parts by mass with respect to 100 parts by mass of the helical chiral polymer.

**17.** The layered body according to claim 16, wherein the stabilizer has a functional group selected from the group consisting of a carbodiimide group, an epoxy group, and an isocyanate group, in a molecule.

**18.** The layered body according to claim 6, wherein the polymeride is a polymeride of a compound having a (meth)acrylic group.

**19.** The layered body according to claim 6 or claim 18, wherein the polymeride is an active energy ray curable resin cured by irradiation with an active energy ray.

**20.** The layered body according to claim 6 or claim 18, wherein a ratio of acrylic terminals of a polymer contained in the crystalline polymeric piezoelectric body, which is determined by measuring a $^1$H-NMR spectrum with respect to a solution obtained by dissolving 20 mg of the crystalline polymeric piezoelectric body in 0.6 mL of deuterated chloroform and calculating a ratio of acrylic terminals of the polymer by the following Formula (X) based on the measured $^1$H-NMR spectrum, is from $2.0\times10^{-5}$ to $10.0\times10^{-5}$:

Ratio of acrylic terminals of the polymer = Integral value of peak derived from acrylic terminals of the polymer / Integral value of peak derived from methine groups in main chains of the polymer Formula (X).

FIG.1

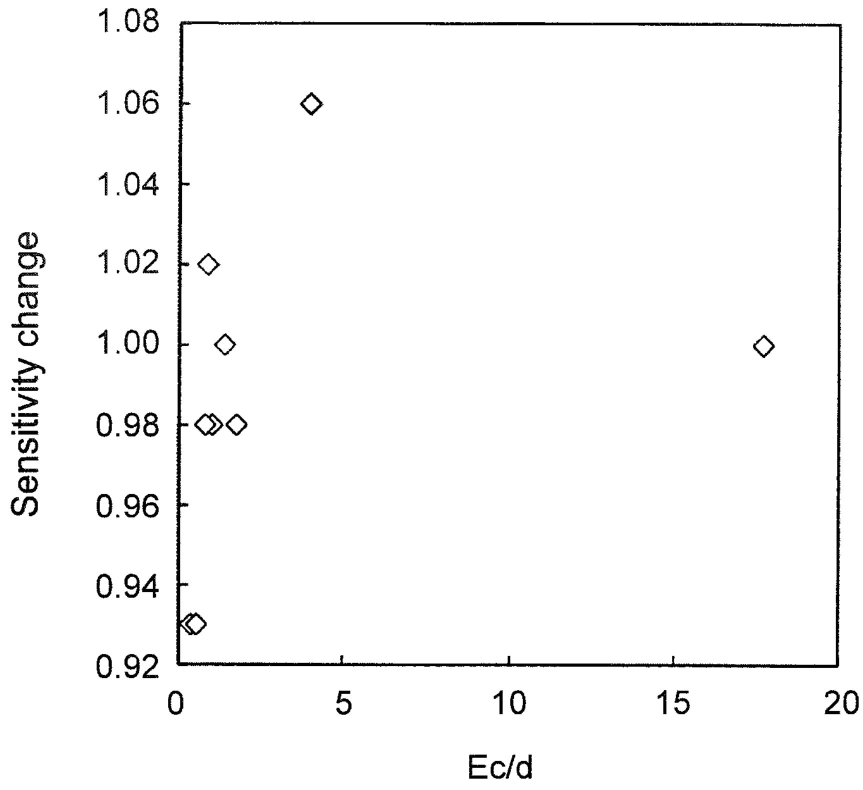
1.08
1.06
1.04
1.02
1.00
0.98
0.96
0.94
0.92
Sensitivity change
0
5
10
15
20
Ec/d

FIG.2

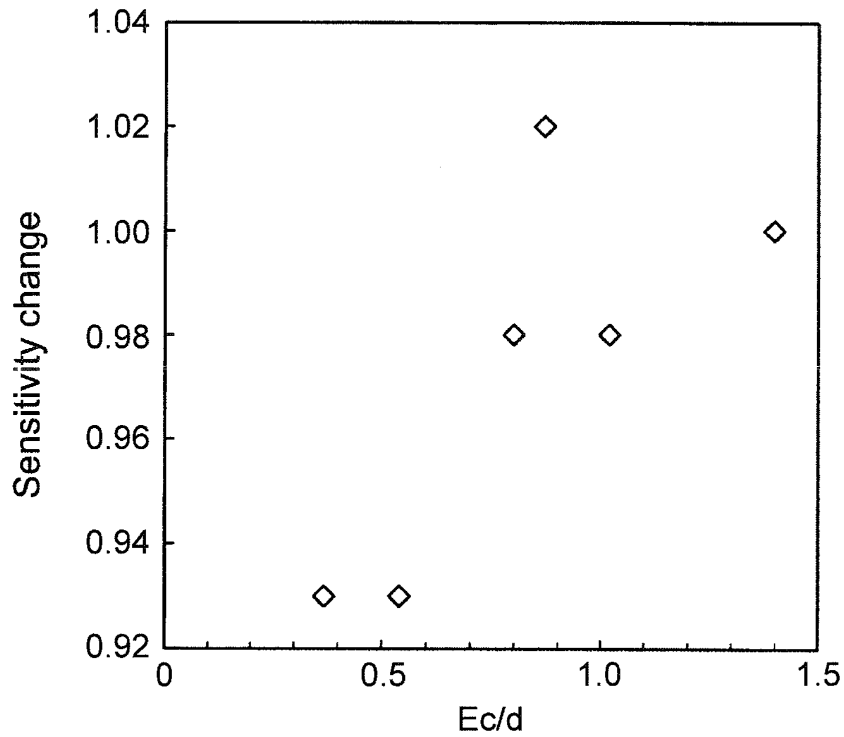
1.04
1.02
1.00
0.98
0.96
0.94
0.92
Sensitivity change
0
0.5
1.0
1.5
Ec/d

FIG.3

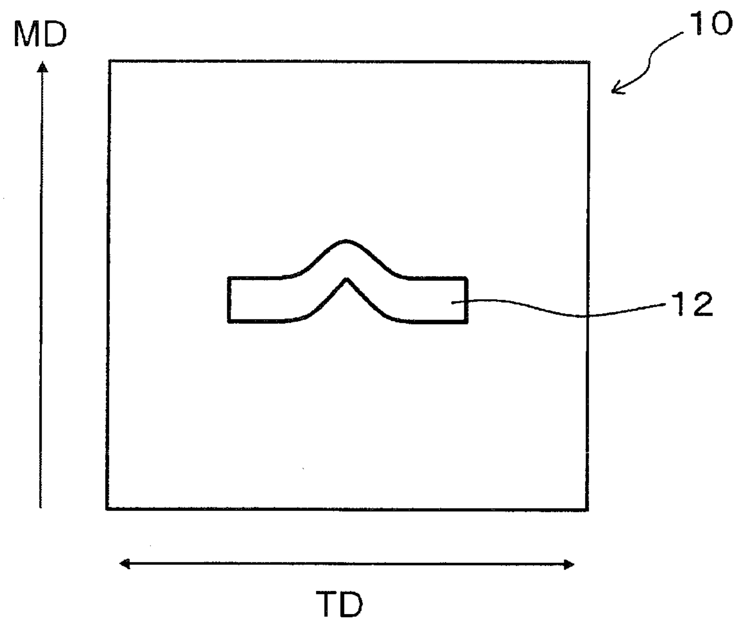

**INTERNATIONAL SEARCH REPORT**

International application No. PCT/JP2014/060340

A. CLASSIFICATION OF SUBJECT MATTER
*B32B7/02*(2006.01)i, *B32B27/36*(2006.01)i, *H01L41/193*(2006.01)i

According to International Patent Classification (IPC) or to both national classification and IPC

B. FIELDS SEARCHED

Minimum documentation searched (classification system followed by classification symbols)
B32B1/00-43/00, H01L41/00-41/47

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2012-56239 A (Mitsui Chemicals, Inc.), 22 March 2012 (22.03.2012), claims 1 to 3, 5; paragraphs [0007], [0023], [0025], [0028], [0033], [0034], [0039], [0043], [0054] (Family: none) | 1-5,8,9, 11-14,18,19<br>6,10,15-17<br>7,20 |
| Y | WO 2012/026494 A1 (Mitsui Chemicals, Inc.), 01 March 2012 (01.03.2012), paragraphs [0062], [0063], [0069] & JP 4934235 B & JP 2012-235086 A & US 2012/0132846 A1 & EP 2469618 A1 & CN 102484199 A & KR 10-2012-0058536 A | 6,10,15 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>09 June, 2014 (09.06.14) | Date of mailing of the international search report<br>24 June, 2014 (24.06.14) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2014/060340

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2006-328284 A (Kuraray Co., Ltd.), 07 December 2006 (07.12.2006), paragraphs [0012], [0027], [0028] (Family: none) | 16,17 |
| A | JP 2011-89072 A (Namics Corp.), 06 May 2011 (06.05.2011), claims (Family: none) | 1-20 |
| A | JP 2010-259000 A (Murata Mfg. Co., Ltd.), 11 November 2010 (11.11.2010), claims & US 2010/0269319 A1 | 1-20 |
| A | JP 2012-109399 A (NGK Insulators, Ltd.), 07 June 2012 (07.06.2012), claims (Family: none) | 1-20 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H5152638 A
- JP 2005213376 A
- WO 2010143528 A
- JP 2006268018 A
- JP 2009192611 A
- JP 2009021408 A
- JP S59096123 A
- JP H7033861 A
- US 2668182 A
- US 4057357 A
- JP H912688 A
- JP 2001525473 A
- JP 2007077193 A
- US 2941956 A
- JP S4733279 B
- JP 4084953 B
- JP 2013227547 A
- JP 2013082392 A
- JP 2013090766 A
- JP 2014022550 A


### Non-patent literature cited in the description


- *J. Org. Chem.,* 1963, vol. 28, 2069-2075
- *Chemical Review,* 1981, vol. 81 (4), 619-621